# EUROPÄISCHE PATENTSCHRIFT

(11) **EP 3 769 420 B1**
(45) Veröffentlichungstag und Bekanntmachung des Hinweises auf die Patenterteilung: **10.06.2026**
(21) Anmeldenummer: 19708094.8
(22) Anmeldetag: 27.02.2019
(51) Int. Cl.: H03K 17/955

(54) **ANORDNUNG FÜR EINE KAPAZITIVE SENSORVORRICHTUNG EINES FAHRZEUGES**
ARRANGEMENT FOR A CAPACITIVE SENSOR DEVICE OF A VEHICLE
SYSTÈME POUR UN DISPOSITIF DE DÉTECTION CAPACITIF D'UN VÉHICULE

(30) Priorität: 21.03.2018 DE 102018106623
(43) Veröffentlichungstag der Anmeldung: 27.01.2021
(73) Patentinhaber: Huf Hülsbeck & Fürst GmbH & Co. KG, 42551 Velbert (DE)
(72) Erfinder: SIEG, Berthold, 46240 Bottrop (DE)
(74) Vertreter: Bals & Vogel Patentanwälte PartGmbB
(86) Internationale Anmeldenummer: PCT/EP2019/054822
(87) Internationale Veröffentlichungsnummer: WO 2019/179727

(56) Entgegenhaltungen:
- WO-A1-2016/107910
- DE-A1- 102012 102 422
- DE-A1- 102012 105 266
- DE-A1- 102012 224 037
- DE-A1- 102013 112 909
- DE-A1- 102013 112 910
- US-A1- 2017 373 686
- "Capacitive Sensors: Design and Applications", 1 January 1997, WILEY-IEEE PRESS, ISBN: 978-0-7803-5351-0, article LARRY K. BAXTER: "Carrier", pages: 171 - 173, XP055587002
- ROBERT KEIM: "How to Low-Pass Filter a Square Wave", 7 March 2018 (2018-03-07), pages 1 - 9, XP055586988, Retrieved from the Internet <URL:https://www.allaboutcircuits.com/technical-articles/how-to-low-pass-filter-a-square-wave/> [retrieved on 20190508]
- ROBERT KEIM: "How to Low-Pass Filter a Square Wave", 7 March 2018 (2018-03-07), pages 1 - 9, XP055586988, Retrieved from the Internet <URL:https://www.allaboutcircuits.com/technical-articles/how-to-low-pass-filter-a-square-wave/> [retrieved on 20190508]
- "Capacitive Sensors: Design and Applications", 1 January 1997, WILEY-IEEE PRESS, ISBN: 978-0-7803-5351-0, article LARRY K. BAXTER: "Carrier", pages: 171 - 173, XP055587002

## Beschreibung

Die vorliegende Erfindung betrifft eine Anordnung für eine kapazitive Sensorvorrichtung eines Fahrzeuges. Ferner bezieht sich die Erfindung auf eine Sensorvorrichtung, einen Außentürgriff sowie ein Verfahren zum Betreiben einer kapazitiven Sensorvorrichtung eines Fahrzeuges.

Es ist aus dem Stand der Technik bekannt, dass eine kapazitive Sensorvorrichtung mit einem Sensorelement an einem Fahrzeug genutzt werden kann, um Veränderungen in der Umgebung des Sensorelements, wie eine Bewegung oder eine Annäherung einer Person, zu detektieren. Zur Auswertung des Sensorelements kann dieses wiederholt aufgeladen und entladen werden, was entsprechend mit einer Ausgabe und einem Empfang elektrischer Signale innerhalb der Sensorvorrichtung einhergeht. Hierzu werden meist periodische Rechteck-Signale genutzt, welche aufgrund des Umladens und/oder eines Umschaltens zwischen einem Entlade- und einem Auflade-Strompfad entstehen können.

Aus der WO 2016 / 1 079 10 A1 ist eine kapazitive Sensorvorrichtung mit wenigstens einer Sensorelektrode zur Erfassung einer Veränderung in einer Umgebung des kapazitiven Sensors bekannt. Es ist dabei vorgesehen, dass ein sinusförmiges Signal an der Sensorelektrode direkt durch eine Spannungsquelle erzeugt wird.

Das Dokument "Capacitive Sensors: Design and application" von Larry K. Baxter vom 1. Januar 1997 diskutiert die Erzeugung einer Sinuswelle.

Im Dokument "How to Low-Pass Filter a Square Wave" von Robert Keim vom 7. März 2018 wird die Tiefpassfilterung einer Sinuswelle diskutiert.

Zur Auswertung des Sensorelements sind z. B. Umladeverfahren bekannt, wie sie in DE 10 2012 102 422 A1, DE 10 2012 105 266 A1, DE 10 2013 112 909 A1 oder DE 10 2013 112 910 A1 offenbart sind.

Ein häufiges Problem ist dabei, dass ein solches Signal zur Auswertung, und insbesondere ein Rechtecksignal, ein Spektrum mit ungünstigen Frequenzen aufweisen kann. So ist es denkbar, dass es bei der Umladung mittels des Signals an dem Sensorelement zu einer störenden Abstrahlung kommt. Entsprechend ist es oft eine technische Herausforderung und mit aufwendigen Maßnahmen verbunden, Störauswirkungen durch die Sensorvorrichtung auf die Umgebung zu reduzieren. Beispielsweise kann es zu Problemen aufgrund von Wechselwirkungen mit Funksignalen im Bereich von 510 kHz bis 1,71 MHz kommen. Solche Funksignale werden insbesondere durch externe Sender des Mittelwellenrundfunks (im AM-Band) oder dergleichen abgestrahlt. Die Maßnahmen zur Reduzierung und/oder Kompensation dieser Wechselwirkungen sind dabei häufig technisch komplex und kostenintensiv.

Es ist daher eine Aufgabe der vorliegenden Erfindung, die voranstehend beschriebenen Nachteile zumindest teilweise zu beheben. Insbesondere ist es eine Aufgabe der vorliegenden Erfindung, einen verbesserten Betrieb einer kapazitiven Sensorvorrichtung eines Fahrzeuges zu ermöglichen.

Die voranstehende Aufgabe wird gelöst durch eine Anordnung mit den Merkmalen des unabhängigen Vorrichtungsanspruchs, eine Sensorvorrichtung mit den Merkmalen des nebengeordneten Vorrichtungsanspruchs, ein Außentürgriff mit den Merkmalen des weiteren nebengeordneten Vorrichtungsanspruchs sowie durch ein Verfahren mit den Merkmalen des unabhängigen Verfahrensanspruchs. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Anordnung beschrieben sind, selbstverständlich auch im Zusammenhang mit der erfindungsgemäßen Sensorvorrichtung, dem erfindungsgemäßen Außentürgriff sowie dem erfindungsgemäßen Verfahren, und jeweils umgekehrt, so dass bezüglich der Offenbarung zu den einzelnen Erfindungsaspekten stets wechselseitig Bezug genommen wird bzw. werden kann.

Die Aufgabe wird insbesondere gelöst durch eine Anordnung nach Anspruch 1, zur Detektion einer Aktivierungshandlung beim Fahrzeug (z. B. im Front- und/oder Seiten- und/oder Heckbereich des Fahrzeuges). Die Aktivierungshandlung kann dabei z. B. durch eine Person in der Umgebung des Fahrzeuges durchgeführt werden. So kann die Person den Wunsch haben, eine Heckklappe des Fahrzeuges durch eine Geste am Heckbereich zu öffnen. Diese Geste ist z. B. ein Bewegen eines Körperteils unterhalb eines Stoßfängers, was durch die Sensorvorrichtung detektiert werden kann. Auch kann ggf. eine Geste in der Umgebung zu einem Türgriff des Fahrzeuges als Aktivierungshandlung vorgesehen sein, um z. B. eine Fahrzeugtür zu entriegeln und/oder zu öffnen.

Erfindungsgemäß weist die Anordnung die nachfolgenden Komponenten auf:
- wenigstens eine Sensorelektrode, zur Erfassung einer Veränderung in einer Umgebung des Fahrzeuges, insbesondere in einer Umgebung des Sensorelements, vorzugsweise in einem Bereich außerhalb des Fahrzeuges und/oder unterhalb eines Stoßfängers und/oder im Bereich eines Türgriffes, bevorzugt zur Erfassung der Geste und/oder der Aktivierungshandlung,
- eine Übertragungsanordnung zur frequenzabhängigen und/oder phasenabhängigen Übertragung, vorzugsweise zur frequenz- und/oder phasenabhängigen Veränderung, eines elektrischen Eingangssignals, insbesondere Ansteuerungssignals, und Ausgabe eines (elektrischen) Ausgangssignals, welches vorzugsweise vom (frequenz- und/oder phasenabhängig übertragenen / veränderten) Eingangssignal abhängig ist, und bevorzugt als zwangsgeführte Sensorspannung und/oder als zwangsgeführter Sensorstrom ausgebildet ist,
- einen Ausgang der Übertragungsanordnung, welcher elektrisch mit dem Sensorelement bzw. der Sensorelektrode direkt oder indirekt verbunden ist, um das Ausgangssignal an dem Sensorelement bzw. der Sensorelektrode auszugeben,
- einen Eingang der Übertragungsanordnung, an welchem das Eingangssignal bereitgestellt ist.

Hierbei ist erfindungsgemäß vorgesehen, dass die Übertragungsanordnung eine gesteuerte Quellenvorrichtung aufweist, um das Ausgangssignal in Abhängigkeit von der frequenzabhängigen und/oder phasenabhängigen Übertragung, vorzugsweise frequenz- und/oder phasenabhängigen Veränderung des Eingangssignals (d. h. insbesondere gesteuert von dem übertragenen / veränderten Eingangssignal) zu erzeugen, und bevorzugt als ein geführtes elektrisches Signal an der Sensorelektrode auszugeben. Dies hat den Vorteil, dass das Spektrum des Eingangssignals durch die Übertragungsanordnung angepasst werden kann, also z. B. (ungewünschte) störende Frequenzen des Eingangssignals herausgefiltert werden und/oder bei dem Ausgeben des Ausgangssignals an der Sensorelektrode vermieden werden können. Darüber hinaus kann aber auch durch die Nutzung der Quellenvorrichtung besonders zuverlässig gewährleistet werden, dass das an der Sensorelektrode anliegende Signal auch weiterhin (im Wesentlichen, z. B. innerhalb einer vorgegebenen Toleranz) das durch die Übertragungsanordnung angepasste Spektrum aufweist. Dabei basiert die erfindungsgemäße Lösung insbesondere auf der Überlegung, dass die Nutzung eines Rechtecksignals als Ausgangssignal für die Sensorelektrode hinsichtlich möglicher Störfrequenzen besonders problematisch ist, und ferner insbesondere eine passive Filterung des Eingangssignals nicht ausreichend ist, da bei der Übertragung des Ausgangssignals an die Sensorelektrode ggf. störende Frequenzen entstehen können. Insbesondere kann ansonsten nicht ausreichend gewährleistet werden, dass die Übertragung des Ausgangssignals und/oder die Ausgabe an der Sensorelektrode keine störenden Auswirkungen auf das Ausgangssignal und/oder einer elektromagnetischen Abstrahlung an der Sensorelektrode hat. Daher wird ein besonderer Vorteil dadurch erzielt, dass eine gesteuerte Quellenvorrichtung genutzt wird, um ein geführtes Signal an der Sensorelektrode bereitzustellen. Insbesondere wird eine störungsreduzierte Ausgabe des Ausgangssignals dadurch begünstigt, dass durch die aktive Erzeugung des Ausgangssignals eine Führung des Signals an der Sensorelektrode bewirkt werden kann, wodurch dem Problem von ausgestrahlten Störfrequenzen bei der Ausgabe des Signals an der Sensorelektrode besonders zuverlässig begegnet werden kann.

Vorteilhafterweise kann bei der erfindungsgemäßen Anordnung nur eine einzige (baulich ausgeführte) Sensorelektrode zur Ausbildung einer (veränderlichen) Sensorkapazität vorgesehen sein, wobei vorzugsweise die Gegenelektrode zur Ausbildung der Sensorkapazität durch eine Masse des Fahrzeuges gebildet ist, und damit nicht als separates (dediziertes) Bauteil angesehen wird. Bevorzugt werden parasitäre Kapazitäten der Sensorvorrichtung hierbei vernachlässigt. Dies ermöglicht eine besonders einfache konstruktive Ausgestaltung.

Die Sensorelektrode kann ein Sensorelement aus einem elektrisch leitenden Material sein. Bspw. ist die Sensorelektrode als länglicher (längsgestreckter) elektrischer Leiter ausgeführt, bspw. als elektrisches Kabel, und optional lediglich über eine einzige direkte elektrische Verbindung mit der Fahrzeugelektronik verbunden.

Dabei kann unter einer elektrischen Verbindung sowohl eine direkte als auch eine indirekte Verbindung, d. h. auch über weitere elektrische Bauelemente, verstanden werden, allerdings vorzugsweise nur, sofern die Verbindung ausschließlich elektrisch erfolgt. Bspw. kann das elektrische Feld zwischen der Sensorelektrode und der Fahrzeugmasse hierbei nicht als direkte elektrische Verbindung aufgefasst werden, sodass die Sensorelektrode bevorzugt nur eine einzige direkte elektrische Verbindung zur Fahrzeugelektronik aufweist. Ggf. kann als die Fahrzeugelektronik auch zumindest die Sensorvorrichtung und/oder die Kontrollvorrichtung und/oder die Übertragungsanordnung verstanden werden.

Das Fahrzeug ist vorzugsweise als Kraftfahrzeug, bevorzugt Personenkraftfahrzeug, und/oder als Elektrofahrzeug und/oder als Hybridfahrzeug und/oder als autonomes Fahrzeug ausgebildet.

Es ist darüber hinaus denkbar, dass das wenigstens eine Sensorelement, vorzugsweise die wenigstens eine Sensorelektrode, in einem Front- und/oder Seiten- und/oder Heckbereich des Fahrzeuges angeordnet ist, um insbesondere die Veränderung in der Umgebung und/oder die Aktivierungshandlung entsprechend im genannten Umgebungsbereich, d. h. Front- und/oder Seiten- und/oder Heckbereich des Fahrzeuges, zu erfassen. Auf diese Weise kann die Aktivierungshandlung in diesem Umgebungsbereich zuverlässig durch die Sensorvorrichtung detektiert werden. Es können z. B. intuitiv anhand der Detektion Elemente und/oder Funktionen des Fahrzeuges in diesem Umgebungsbereich bewegt bzw. aktiviert werden. Solche Funktionen sind bspw. eine Beleuchtung des Fahrzeuges und/oder ein Entriegeln einer Schließvorrichtung des Fahrzeuges und/oder dergleichen. Die Elemente können z. B. als Heckklappe und/oder Seitentür und/oder Schiebetür und/oder Motorhaube ausgeführt sein, welche anhand der Detektion bewegt und/oder geöffnet und/oder geschlossen werden. Auch ist es optional möglich, dass das Sensorelement an einem und/oder innerhalb eines oder im Bereich eines Türschweller(s) angeordnet ist, um anhand der Detektion z. B. eine Seitentür oder Schiebetür des Fahrzeuges zu öffnen. Damit eine Bewegung und/oder ein Bewegungsmuster zuverlässig anhand der Detektion erfasst werden kann, können alternativ oder zusätzlich zu vorgenannten Merkmalen auch mindestens zwei Sensorelemente, vorzugsweise Sensorelektroden, vorgesehen sein. Diese sind bspw. gemeinsam in wenigstens einem der vorgenannten Umgebungsbereichen angeordnet, z. B. gemeinsam in einem Stoßfänger oder Türschweller oder Türgriff oder dergleichen.

Unter einer gesteuerten Quellenvorrichtung, insbesondere Strom- und/oder Spannungsquellenvorrichtung, kann ein reales elektrisches Bauelement oder eine elektrische Schaltung verstanden werden, welche(s) annähernd die Funktion einer idealen gesteuerten Quelle (engl. auch: "dependent source"), insbesondere Strom- und/oder Spannungsquelle, aufweist. Somit kann die Quellenvorrichtung als reale gesteuerte Quelle, insbesondere reale Stromquelle oder reale Spannungsquelle (CVS, engl. "controlled voltage source"), aufgefasst werden. Ein Beispiel für eine solche Quellenvorrichtung ist ein Operationsverstärker (OP), insbesondere ein gesteuerter, vorzugsweise spannungsgesteuerter, Operationsverstärker. Besonders vorteilhaft ist, wenn die Quellenvorrichtung als eine (reale) niederohmig gesteuerte (Spannungs-) Quelle ausgeführt ist. Die Quellenvorrichtung kann z. B. dadurch niederohmig ausgeführt werden, dass der Innenwiderstand (Ausgangswiderstand) und/oder der Eingangswiderstand der Quellenvorrichtung niederohmig ausgelegt wird, vorzugsweise jeweils unterhalb 1 kOhm oder unterhalb 500 Ohm oder unterhalb oder gleich 100 Ohm, wobei der Innenwiderstand und der Eingangswiderstand auch unterschiedliche Werte haben können. Damit wird die Rückwirkung der nachgelagerten Schaltung auf die Quellenvorrichtung deutlich reduziert, sodass die Eigenschaften des Ausgangssignals und insbesondere auch des Signals welches an der Sensorelektrode anliegt sehr genau bestimmt werden können. In anderen Worten kann das Ausgangssignal als ein geführtes Signal ausgegeben werden, d. h. insbesondere das Signal durch die Quellenvorrichtung aktiv erzeugt werden und/oder aktiv der Signalverlauf an der Sensorelektrode kontrolliert (d. h. gesteuert oder geregelt) werden. Die Quellenvorrichtung ist dabei vorteilhafterweise dazu ausgeführt, eine möglichst rückwirkungsfreie Kopplung zwischen Steuereingang und Ausgang der Quellenvorrichtung zu bewirken. Bei der Quellenvorrichtung kann das Signal (z. B. Strom oder Spannung) am Ausgang der Quellenvorrichtung insbesondere durch ein Steuersignal (Steuerstrom oder - spannung) am Steuereingang der Quellenvorrichtung gesteuert werden. Dieser zusätzliche Schritt und Aufwand für die Integration der Quellenvorrichtung kann erfindungsgemäß in Kauf genommen werden, um den Vorteil einer verbesserten und zuverlässig kontrollierbaren Signalausgabe an der Sensorelektrode durch eine vergleichsweise einfache schaltungstechnische Maßnahme zu erzielen.

Außerdem ist es von Vorteil, wenn die Quellenvorrichtung als eine reale niederohmig gesteuerte Strom- und/oder Spannungsquelle ausgebildet ist, vorzugsweise um das erzeugte Ausgangssignal als ein geführtes elektrisches Signal an der Sensorelektrode auszugeben. Dies hat den Vorteil, dass Einflüsse, welche zwischen der Übertragungsanordnung und der Sensorelektrode auftreten, nur einen verringerten Einfluss auf das Signal haben können.

In einer weiteren Möglichkeit kann vorgesehen sein, dass die Quellenvorrichtung als ein aktives Bauelement ausgebildet ist, bevorzugt als ein Operationsverstärker, wobei vorzugsweise die Quellenvorrichtung (insbesondere direkt) mit einer (eigenen) Versorgungsspannung verbunden ist, um bevorzugt aktiv das Ausgangssignal zu erzeugen, und besonders bevorzugt aktiv das Ausgangssignal durch die Ausgabe an der Sensorelektrode anzulegen. In anderen Worten kann die Ausgabe des Ausgangssignals durch die Quellenvorrichtung erfolgen, um das Ausgangssignal an der Sensorelektrode anzulegen, wobei das Ausgangssignal aktiv mittels der Versorgungsspannung erzeugt wird. Damit können Abweichungen der Signalform beim anliegenden Signal reduziert werden.

Ferner kann es bei der erfindungsgemäßen Anordnung möglich sein, dass die Anordnung und/oder die Übertragungsanordnung und/oder die Filterkomponenten derart dimensioniert sind, dass eine Oberwellenunterdrückung von wenigstens (-) 20 dB, insbesondere (-) 30 dB erfolgt, vorzugsweise ab einer zweiten oder dritten Harmonischen. In anderen Worten kann eine Abschwächung ab der zweiten oder dritten Harmonischen erzielt werden, wobei das Signal ab der zweiten bzw. dritten Harmonischen (z. B. mit wenigstens 20 dB) abgeschwächt wird. Dies hat zur Folge, dass das Ausgangssignal gegenüber dem Eingangssignal für die Frequenz entsprechend der zweiten bzw. dritten Harmonische um wenigstens 20 dB abgeschwächt ist.

Vorzugsweise kann vorgesehen sein, dass die Übertragungsanordnung wenigstens eine Filterkomponente zur Ausbildung eines elektronischen Filters aufweist, vorzugsweise eines Allpass- oder Tief- oder Bandpass-Filters, um die frequenzabhängige und/oder phasenabhängige Übertragung, vorzugsweise frequenz- und/oder phasenabhängige Veränderung, des Eingangssignals durchzuführen. Damit kann eine einfache Maßnahme bereitgestellt werden, um Störfrequenzen zu unterdrücken. Bevorzugt kann die Quellenvorrichtung mit wenigstens einer dieser wenigstens einen Filterkomponente verschaltet sein, sodass ein aktives Filter, besonders bevorzugt ein Sallen-Key-Filter, ausgebildet ist. Bspw. kann das aktive Filter dadurch entstehen, dass ein Operationsverstärker als Quellenvorrichtung genutzt wird. Damit wird insbesondere eine Führung des Signals erzielt.

Ferner kann es im Rahmen der Erfindung vorgesehen sein, dass die Übertragungsanordnung eine erste Filterkomponente, insbesondere zur Ausbildung eines RC-Tiefpass-Filters, vorzugsweise erster Filterordnung, und/oder eine zweite Filterkomponente, insbesondere zur Ausbildung eines Sallen-Key-Filters, vorzugsweise zweiter Filterordnung, aufweist. Es können optional die Filterkomponenten miteinander verschaltet sein, um gemeinsam die frequenzabhängige und/oder phasenabhängige Übertragung, vorzugsweise frequenz- und/oder phasenabhängige Veränderung des Eingangssignals durchzuführen und die Filterordnung der Übertragungsanordnung zu erhöhen. Auch ist es denkbar, dass weitere Filterkomponenten vorgesehen und miteinander verschaltet sind, z. B. um die Filterordnung der Übertragungsanordnung noch weiter zu erhöhen. Insbesondere können die Filterkomponenten lediglich passive Bauelemente aufweisen, um einen Kosten- und/oder Konstruktionsaufwand zu verringern.

Gemäß einem weiteren Vorteil kann vorgesehen sein, dass das Ausgangssignal in Abhängigkeit von der frequenzabhängigen und/oder phasenabhängigen Übertragung, vorzugsweise frequenz- und/oder phasenabhängigen Veränderung, des Eingangssignals dadurch erzeugbar ist, dass die Quellenvorrichtung mit wenigstens einer Filterkomponente verschaltet ist, sodass vorzugsweise das durch die Filterkomponente übertragene / veränderte Eingangssignal an einem Steuereingang der Quellenvorrichtung anliegt, um die Quellenvorrichtung hinsichtlich der Ausgabe des Ausgangssignals zu steuern, und bevorzugt ein Ausgang der Quellenvorrichtung mit dem Ausgang der Übertragungsanordnung verbunden ist oder diesem entspricht. In anderen Worten kann die Übertragungsanordnung zwei Bereiche aufweisen: einen Eingangsbereich mit der wenigstens einen Filterkomponente, durch welche das Eingangssignal frequenz- und/oder phasenabhängig übertragen oder verändert (also gefiltert) wird. Und einen Ausgangsbereich mit der Quellenvorrichtung, welche direkt das Ausgangssignal am Ausgang der Übertragungsanordnung bereitstellen kann, und insbesondere mit der Filterkomponente über einen Steuereingang verbunden ist. Dies hat den Vorteil, dass gesteuert durch das Eingangssignal das Ausgangssignal von der Quellenvorrichtung als geführtes Signal erzeugt werden kann.

In einer weiteren Möglichkeit kann vorgesehen sein, dass eine Eingangssignalquelle (z. B. elektrisch oder optisch und/oder galvanisch getrennt) mit einem Eingang der Übertragungsanordnung verbunden ist, um vorzugsweise das Eingangssignal an dem Eingang bereitzustellen, wobei bevorzugt die Eingangssignalquelle hierzu wenigstens eine Ansteuerungsvorrichtung, insbesondere mit einem Digital-Analog-Wandler und/oder Mikrocontroller, aufweist. Bspw. kann eine Software des Mikrocontrollers das Eingangssignal direkt erzeugen (und bspw. ein Digital-Analog-Wandler ausgeben), und somit ggf. auch eine weitergehende Signalformung beim Eingangssignal durchführen. Ferner ist es denkbar, dass die Ansteuerungsvorrichtung zur Ansteuerung eines elektronischen Schalterelements oder dergleichen ausgeführt ist, um das Eingangssignal als Rechtecksignal zu erzeugen. Damit ist eine einfache Signalerzeugung zur Auswertung der Sensorelektrode möglich.

Nach einer weiteren Möglichkeit kann vorgesehen sein, dass die Übertragungsanordnung dazu ausgeführt ist, eine Unterdrückung von Oberschwingungen des Eingangssignals durchzuführen, um vorzugsweise eine Emission von Signalen in einem störenden Frequenzbereich durch die Sensorelektrode zumindest zu reduzieren. Unter der Emission wird dabei insbesondere eine Ausstrahlung von elektromagnetischen Wellen durch die Sensorelektrode verstanden, welche in Abhängigkeit von dem Ausgangssignal erfolgt. In anderen Worten kann die frequenzabhängige und/oder phasenabhängige Übertragung, vorzugsweise frequenz- und/oder phasenabhängige Veränderung, durch die Übertragungsanordnung den Frequenzbereich beeinflussen, aus dem die Emission erfolgt. Damit wird eine Steuerung der Emission möglich, um bspw. Grenzwerte zuverlässig einzuhalten.

Optional ist es denkbar, dass die Quellenvorrichtung elektrisch mit einer Fahrzeugelektronik, insbesondere einer Kontrollvorrichtung, verbunden ist, um vorzugsweise eine Abschaltung der Quellenvorrichtung durchzuführen, sodass die Anordnung in einen Energiesparmodus überführbar ist. Dies Abschaltung kann bspw. dadurch ausgelöst werden, dass eine bestimmte Zeitdauer abgelaufen ist, in welcher eine Inaktivität vorlag (z. B. keine Aktivierungshandlung erfolgt ist). Die Nutzung der Quellenvorrichtung hat dabei den Vorteil, dass diese in einfacher Weise abgeschaltet werden kann, und somit zur Reduzierung des Energieverbrauchs beitragen kann.

Erfindungsgemäß ist es vorgesehen, dass eine Eingangssignalquelle derart zur Bereitstellung des Eingangssignals ausgeführt ist, dass das Eingangssignal als ein auf ein Rechtecksignal basierendes Signal ausgeführt ist, welches durch Signalformung aktiv verändert ist, und zwar durch ein Verschleifen der Flanken des Rechtecksignals und/oder insbesondere durch eine zeitlich veränderliche Amplitude, um die frequenz- und/oder phasenabhängige Übertragung und/oder insbesondere Veränderung, vorzugsweise eine Oberwellenunterdrückung, durch die Übertragungsanordnung zu unterstützen. In anderen Worten erfolgt bereits vor der frequenz- und/oder phasenabhängigen Übertragung bzw. Veränderung durch die Übertragungsanordnung eine Signalformung, um die Veränderung durch die Übertragungsanordnung zu verbessern. Als besonders vorteilhaft hat es sich hierbei herausgestellt, dass das Eingangssignal mittels der Signalformung mit einer Stufenform erzeugt wird, und diese mit einem "Verschleifen" im Sinne einer zeitlich veränderlichen Amplitude kombiniert wird. Diese Art der Signalformung soll vereinfacht als "sinusartige Stufenform" bezeichnet werden. Anhand eines derart geformten Eingangssignals kann durch die Übertragungsanordnung besonders zuverlässig ein möglichst sinusartiges Ausgangssignal erzeugt werden, welches somit eine geringe Frequenzbandbreite und entsprechend nur geringe Störfrequenzen außerhalb der Arbeitsfrequenz aufweist.

Insbesondere wird unter Verschleifen verstanden, dass z. B. durch ein Tiefpass oder durch einen entsprechenden Betrieb der Ansteuerungsvorrichtung und/oder eines Digital-Analog-Wandlers und/oder dergleichen eine zeitliche Amplitudenveränderung hervorgerufen wird und/oder die Flankensteilheit des Eingangssignals herabgesenkt wird.

Es ist bevorzugt vorgesehen, dass die frequenz- und/oder phasenabhängige Übertragung und/oder Veränderung eine Oberwellenunterdrückung ist, insbesondere ab einer zweiten oder dritten Harmonischen des Eingangssignals. Alternativ oder zusätzlich kann es möglich sein, dass die frequenz- und/oder phasenabhängige Übertragung und/oder Veränderung als eine Übertragung im Sinne eines Allpassfilters ausgeführt ist, also z. B. mit einem (im Wesentlichen) konstanten Betragsfrequenzgang für alle (wesentlichen) Frequenzen des Eingangssignals, während ggf. die Phasenverschiebung von der Frequenz abhängt. Die Übertragungsanordnung kann das Ausgangssignal z. B. auch als ein Rechtecksignal oder dergleichen bereitstellen. Ferner ist es denkbar, dass die Übertragungsanordnung als eine elektrische Leitung oder dergleichen ausgeführt ist, und somit das Eingangssignal (hinsichtlich der Signalform) im Wesentlichen unverändert überträgt und als Ausgangssignal ausgibt, z. B. als ein auf ein Rechtecksignal basierendes Signal. Entsprechend kann die frequenz- und/oder phasenabhängige Übertragung und/oder Veränderung einen konstanten Betragsfrequenzgang und/oder Phasengang aufweisen. Alternativ kann die Übertragungsanordnung auch einen nicht-konstanten Betragsfrequenzgang und/oder Phasengang aufweisen. Besonders vorteilhaft ist dabei die Bereitstellung des Ausgangssignals als sinusartiges Signal, was z. B. durch eine frequenzabhängige Veränderung des Eingangssignals im Sinne einer Tiefpass- und/oder Bandpass-Filterung insbesondere zur Oberwellenunterdrückung möglich ist.

Sowohl bei der Nutzung eines rechteckartigen Signals als auch eines sinusartigen Signals als Ausgangssignal - und auch bei anderen gewünschten Signalarten - kann der Einsatz der gesteuerten Quellenvorrichtung deutliche Vorteile bieten. Es lässt sich damit gewährleisten, dass das Ausgangssignal stets die gewünschte Signalform an der Sensorelektrode aufweist. Daher ist die erfindungsgemäße Anordnung grundsätzlich für alle denkbaren Signalarten bzw. Signalformen des Eingangs- und/oder Ausgangssignals einsetzbar und unter Schutz gestellt.

In einer weiteren Möglichkeit kann vorgesehen sein, dass eine Kontrollvorrichtung vorgesehen ist, welche elektrisch mit der Sensorelektrode verschaltet ist, um vorzugsweise die Erfassung der Veränderung in der Umgebung des Fahrzeuges durch die wenigstens eine Sensorelektrode dadurch auszuwerten, dass eine veränderliche Kapazität der Sensorvorrichtung mittels des Ausgangssignals durch die Kontrollvorrichtung auswertbar ist, wobei bevorzugt die veränderliche Kapazität von der Sensorelektrode und der Umgebung abhängig ist, wobei besonders bevorzugt die elektrische Verschaltung derart ausgeführt ist, dass eine Umladung einer elektrischen Ladung der Sensorelektrode zur Kontrollvorrichtung durchführbar ist, um die veränderliche Kapazität zu bestimmen. Hierzu kann das Ausgangssignal bspw. zur Aufladung der veränderlichen Kapazität in einer Übertragungsphase dienen, und vorzugsweise in einer Umladephase eine Halteanordnung in Abhängigkeit von der veränderlichen Kapazität aufgeladen werden. Durch eine Auswertung der Veränderung der Kapazität der Sensorvorrichtung anhand der Aufladung der Halteanordnung kann dann ggf. die Aktivierungshandlung durch die Kontrollvorrichtung detektiert werden.

Nach einer weiteren Möglichkeit kann vorgesehen sein, dass eine Kontrollvorrichtung vorgesehen ist, um die Erfassung der Veränderung in der Umgebung des Fahrzeuges durch die wenigstens eine Sensorelektrode dadurch auszuwerten, dass in wiederholt durchgeführten Umladephasen eine Halteanordnung der Kontrollvorrichtung in Abhängigkeit von einer veränderlichen Kapazität der Sensorvorrichtung geladen wird, sodass vorzugsweise in den Umladephasen eine Ladungsakkumulation bei der Halteanordnung erfolgt, wobei hierzu insbesondere die Sensorelektrode in jeder Umladephase elektrisch mit der Halteanordnung verbunden wird. Bevorzugt kann ferner das Eingangssignal durch die Kontrollvorrichtung erzeugt und/oder geformt und für die Übertragungsanordnung am Eingang bereitgestellt werden.

Darüber hinaus ist es denkbar, dass ein elektronisches Schalterelement vorgesehen ist, welcher derart durch die Kontrollvorrichtung angesteuert wird, dass das Schalterelement die wenigstens eine Sensorelektrode wiederholt und abwechselnd mit einem Receive-Pfad und einem Transmit-Pfad verbindet. Dabei kann der Receive-Pfad zu einer Halteanordnung führen, um eine Umladephase durchzuführen, und der Transmit-Pfad zu der Übertragungsanordnung führen, um eine Übertragungsphase durchzuführen.

Ferner kann im Rahmen der Erfindung vorgesehen sein, dass die Anordnung zur Integration in einen Türgriff des Fahrzeuges und/oder in einen Heckbereich und/oder Seitenbereich und/oder Frontbereich des Fahrzeuges und/oder in eine Stoßstange (Stoßfänger) des Fahrzeuges angepasst ist, insbesondere dass die Sensorelektrode eine längliche Erstreckung aufweist, welche an die Länge des Türgriffs und/oder der Stoßstange und/oder an eine Erstreckung des Fahrzeughecks in Fahrzeugquerrichtung angepasst ist. Dabei kann es möglich sein, dass die Sensorelektrode als elektrische Leitung mit einer Länge ausgebildet ist, welche wenigstens 50 % oder wenigstens 80 % der Länge des Türgriffs oder der Stoßstange entspricht. Somit wird ein besonders ausgedehnter Erfassungsbereich ermöglicht. Zumindest eine Sensorelektrode in der Stoßstange kann als sogenannter Kick-Sensor dienen, so dass die vorliegende Erfindung ebenfalls auf einen Kick-Sensor mit der erfindungsgemäßen Sensorvorrichtung gerichtet ist. Ferner ist es ebenfalls denkbar, dass die Sensorelektrode eine von einer länglichen Erstreckung abweichende Erstreckung aufweist, z. B. im Wesentlichen eine Kreisform oder Rechteckform oder Punktform oder dergleichen.

Zudem ist im Rahmen der Erfindung denkbar, dass die Übertragungsanordnung und/oder die Quellenvorrichtung derart mit der Sensorelektrode verbunden ist, dass ein elektrisches Signal und/oder eine Signalform des Signals direkt an der Sensorelektrode mindestens zu 80 % dem Ausgangssignal und/oder der Signalform des Ausgangssignals entspricht, wobei vorzugsweise das Ausgangssignal unmittelbar an der Quellenvorrichtung ausgebbar ist. Hierdurch kann gewährleistet werden, dass die störenden Frequenzen zuverlässig reduziert sind.

Ebenfalls Gegenstand der Erfindung ist eine Sensorvorrichtung für ein Fahrzeug, aufweisend:
- eine Anordnung, insbesondere eine erfindungsgemäße Anordnung,
- eine Kontrollvorrichtung, welche mit der Anordnung elektrisch verbunden ist, um ein Eingangssignal zur Auswertung einer veränderlichen Kapazität der Sensorvorrichtung für die Anordnung bereitzustellen. Hierbei ist vorgesehen, dass die Kontrollvorrichtung elektrisch mit einer Fahrzeugelektronik verbindbar ist, um eine Fahrzeugfunktion (wie eine Authentifizierung z. B. mit einem Identifikationsgeber und/oder ein Entriegeln und/oder ein Öffnen einer Heckklappe und/oder einer Tür des Fahrzeuges) in Abhängigkeit von der Auswertung zu aktivieren. Bspw. kann bei positiv detektierter Aktivierungshandlung eine Authentifizierung initiiert werden, um bei positiver Authentifizierung das Öffnen und/oder Entriegeln zu bewirken. Damit bringt die erfindungsgemäße Sensorvorrichtung die gleichen Vorteile mit sich, wie sie ausführlich mit Bezug auf eine erfindungsgemäße Anordnung beschrieben worden sind.

Ebenfalls unter Schutz gestellt ist ein Außentürgriff für ein Fahrzeug mit einer erfindungsgemäßen Anordnung.

Ebenfalls Gegenstand der Erfindung ist ein Verfahren zum Betreiben einer kapazitiven Sensorvorrichtung eines Fahrzeuges, insbesondere zur Ansteuerung und/oder Auswertung bei der kapazitiven Sensorvorrichtung zur Detektion einer Aktivierungshandlung beim Fahrzeug, z. B. im Front- und/oder Seiten- und/oder Heckbereich des Fahrzeuges,wobei die kapazitive Sensorvorrichtung (20) eine erfindungsgemäße Anordnung (10) nach einem der Ansprüche 1-9 aufweist.

Vorteilhafterweise kann bei einem erfindungsgemäßen Verfahren zumindest einer der nachfolgenden Schritte durchgeführt werden, wobei die Schritte bevorzugt nacheinander in der angegebenen Reihenfolge oder in beliebiger Reihenfolge durchgeführt werden, und ggf. auch einzelne Schritte wiederholt werden können:
a) Erzeugen eines elektrischen Eingangssignals,
b) Durchführen einer frequenz- und/oder phasenabhängigen Übertragung und/oder Veränderung des elektrischen Eingangssignals,
c) Ausgabe eines Ausgangssignals derart, dass ein geführtes elektrisches Signal in Abhängigkeit von der frequenz- und/oder phasenabhängigen Übertragung und/oder Veränderung des Eingangssignals an der Sensorelektrode ausgegeben wird, insbesondere dadurch, dass eine Quellenvorrichtung in Abhängigkeit von dem übertragenen und/oder veränderten elektrischen Eingangssignal gesteuert wird, und abhängig von der Steuerung das Ausgangssignal erzeugt und/oder bei der Sensorelektrode ausgibt.

Damit bringt das erfindungsgemäße Verfahren die gleichen Vorteile mit sich, wie sie ausführlich mit Bezug auf eine erfindungsgemäße Anordnung beschrieben worden sind.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Es zeigen:
- Fig. 1: eine perspektivische Darstellung eines Hecks eines Fahrzeuges mit einem Benutzer,
- Fig. 2: ein schematisches Prinzip-Schaltbild einer Sensorvorrichtung,
- Fig. 3: eine schematische Darstellung einer erfindungsgemäßen Anordnung,
- Fig. 4: eine schematische Darstellung einer Sensorvorrichtung,
- Fig. 5: schematische Darstellungen von Signalverläufen,
- Fig. 6: eine weitere schematische Darstellung einer erfindungsgemäßen Anordnung.

In den nachfolgenden Figuren werden für die gleichen technischen Merkmale auch von unterschiedlichen Ausführungsbeispielen die identischen Bezugszeichen verwendet.

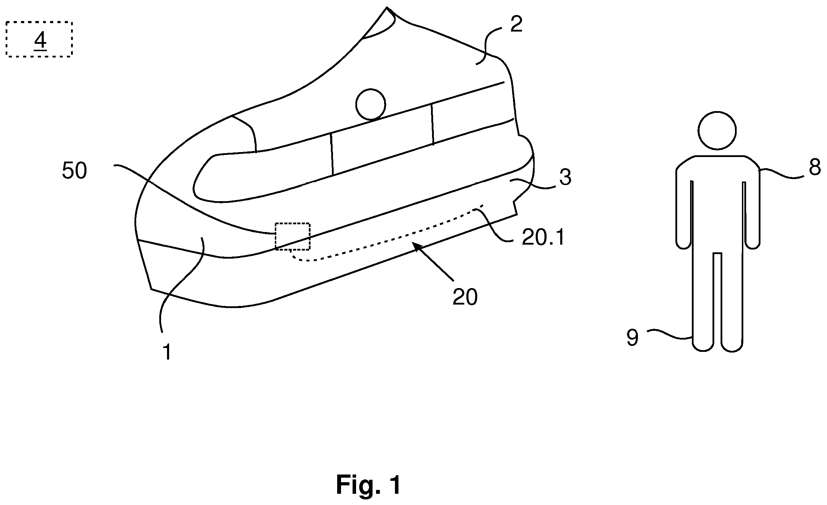

Figur 1 zeigt schematisch eine perspektivische Ansicht eines Fahrzeuges 1. Es ist eine Heckklappe 2 oberhalb eines Stoßfängers 3 des Fahrzeuges 1 dargestellt, wobei die Heckklappe 2 bspw. gemäß einer (ersten) Fahrzeugfunktion geöffnet und/oder gemäß einer (zweiten) Fahrzeugfunktion wieder geschlossen werden kann. Es kann in den Stoßfänger 3 wenigstens ein Sensorelement 20.1, insbesondere eine Sensorelektrode 20.1, einer kapazitiven Sensorvorrichtung 20 integriert sein. Alternativ oder zusätzlich kann das wenigstens eine Sensorelement 20.1 auch in einen (Außen-) Türgriff 4 des Fahrzeuges 1 oder einer sonstigen Fahrzeugkomponente integriert sein. Die kapazitive Sensorvorrichtung 20 weist entsprechend einen kapazitiven Sensor auf, welcher zumindest teilweise durch das Sensorelement 20.1 gebildet wird. Das Sensorelement 20.1 ist bevorzugt kabelförmig und/oder mit einer länglichen Erstreckung ausgebildet, um einen möglichst gestreckten Erfassungsbereich zur Erfassung einer Aktivierungshandlung bereitzustellen. Auch ist es denkbar, dass das Sensorelement 20.1 eine von einer länglichen Erstreckung abweichende Erstreckung aufweist, z. B. im Wesentlichen eine Kreisform oder Rechteckform oder Punktform oder dergleichen. Die Aktivierungshandlung ist bspw. die Bewegung eines Aktivierungsmittels 9, wie eines Körperteils 9, insbesondere Fußes 9, eines Benutzers 8 in einer Umgebung außerhalb des Fahrzeuges 1 bzw. des Sensorelements 20.1. Zur Durchführung der Aktivierungshandlung ist eine Möglichkeit, dass der Benutzer 8 das Aktivierungsmittel 9 unter den Stoßfänger 3 bewegt. Diese Bewegung wird dann als Veränderung einer Sensorkapazität CS der kapazitiven Sensorvorrichtung 20 erfasst, und kann vorzugsweise durch eine Kontrollvorrichtung 50 der Sensorvorrichtung 20 ausgewertet und detektiert werden. Die Kontrollvorrichtung 50 wird hierzu mit dem Sensorelement 20.1 elektrisch verbunden und/oder verschaltet. Entsprechend kann es sinnvoll sein, wenn die Kontrollvorrichtung 50 als Steuergerät des Fahrzeuges 1 ausgebildet ist, vorzugsweise als Teil der - oder elektrisch verbunden mit der - Fahrzeugelektronik. Dabei ist es denkbar, dass zur Reduzierung des Schaltungsaufwandes lediglich eine einzige elektrische Verbindung, z. B. eine einzige elektrische Leitung wie ein Kabel, von der Kontrollvorrichtung 50 zum Sensorelement 20.1 führt, dieses also nur über eine einzige elektrisch leitende Verbindung verbunden ist. Damit entspricht das Sensorelement 20 einer Sensorelektrode 20.1 zur Bereitstellung der Sensorkapazität CS. Weiter ist es möglich, dass eine Detektion der Aktivierungshandlung durch die Kontrollvorrichtung 50 erfolgt, welche sodann die Fahrzeugfunktion oder wenigstens eine der Fahrzeugfunktionen aktiviert.

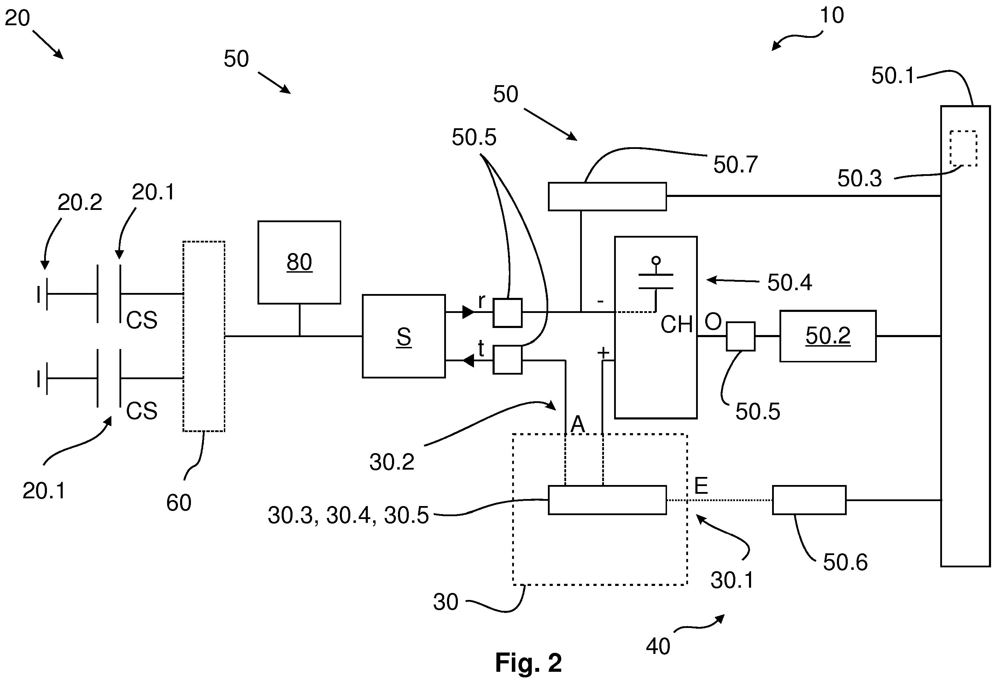

In Figur 2 ist das Erfassungsprinzip zur Detektion der Aktivierungshandlung und zur Auswertung der Sensorkapazität CS näher anhand eines Prinzip-Schaltbilds der kapazitiven Sensorvorrichtung 20 und einer erfindungsgemäßen Anordnung 10, insbesondere Schaltungsanordnung 10, dargestellt. Es können nur ein oder ggf. auch mehrere Sensorelemente 20.1 vorgesehen sein. Beispielhaft gezeigt sind in Figur 2 zwei Sensorelemente 20.1 in der Form von Sensorelektroden 20.1, welche jeweils eine Sensorkapazität CS bereitstellen können. In anderen Worten kann ein Sensorelement 20.1 bzw. eine Sensorelektrode 20.1 jeweils einen kapazitiven Sensor bereitstellen, welcher jeweils als Kondensator aufgefasst werden kann. Bei mehreren Sensorelementen 20.1 kann wenigstens eine Schaltvorrichtung 60 mit wenigstens einem selektiven Schalter vorgesehen sein, welcher abwechselnd die Sensorelemente 20.1 auswählt, also eine elektrische Verbindung dazu herstellt. Die wenigstens eine Schaltvorrichtung 60 verbindet dabei die Sensorelemente 20.1 abwechselnd z. B. mit einer Vorfilteranordnung 80 und/oder wenigstens einem Schalterelement S. Die Nutzung von wenigstens zwei Sensorelementen 20.1 hat dabei den Vorteil, dass z. B. Bewegungen und/oder Bewegungsmuster erfasst werden können.

Das jeweilige Sensorelement 20.1 kann ein elektrisch leitendes Material aufweisen, um jeweils eine (einzige) Sensorelektrode 20.1 auszubilden. Zur Bereitstellung der Sensorkapazität CS genügt es dabei, wenn lediglich die jeweilige Sensorelektrode 20.1 ohne Gegenelektrode vorgesehen ist. In diesem Fall sind die in Figur 2 dargestellten Gegenelektroden (gegenüber den jeweiligen Sensorelementen 20.1) lediglich repräsentativ zur Veranschaulichung des Prinzips und nicht als tatsächliches Bauteil anzusehen. Alternativ kann auch wenigstens eine oder für jedes Sensorelement 20.1 eine zugeordnete Gegenelektrode baulich vorgesehen sein.

Jedes Sensorelement 20.1 kann die Sensorkapazität CS gegenüber einem Massepotential 20.2, insbesondere der Fahrzeugmasse, und der Umgebung des Fahrzeuges 1 ausbilden. Die Sensorkapazität CS ist somit durch die Umgebung des Fahrzeuges 1 veränderbar, insbesondere also dann, wenn ein Aktivierungsmittel 9 sich in den Umgebungsbereich des Sensorelements 20.1 bewegt. Auf diese Weise kann anhand der Sensorkapazität CS sehr zuverlässig eine Aktivierungshandlung erfasst werden.

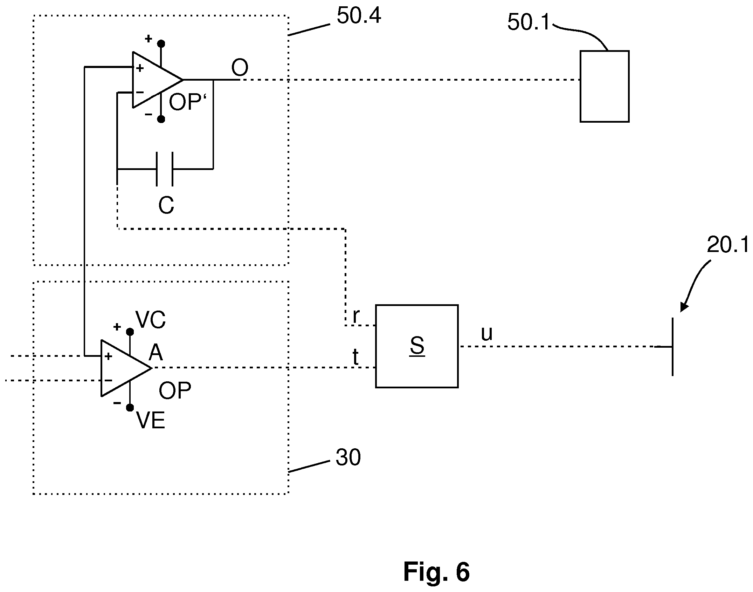

Für die Auswertung der Sensorkapazität CS kommen verschiedene Verfahren in Betracht. Die Verfahren basieren dabei insbesondere darauf, dass eine Umladung der in dem Sensorelement 20.1 befindlichen bzw. der mittels der Sensorkapazität CS gespeicherten Ladung auf eine Halteanordnung 50.4 mit einer Haltekapazität CH bewirkt wird. Es wird dabei der Umstand genutzt, dass die gespeicherte Ladung abhängig von der veränderlichen Sensorkapazität CS und damit von der Umgebung des Fahrzeuges 1 (z. B. der Aktivierungshandlung) ist. Die Halteanordnung 50.4 kann hierbei einen Haltekondensator aufweisen, welcher zur Ladungsakkumulation und/oder Zwischenspeicherung und Auswertung der Ladung durch die Kontrollvorrichtung 50 dient. Vorteilhafterweise weist die Halteanordnung 50.4 einen Operationsverstärker OP' auf, welcher ggf. mit wenigstens einem weiteren Bauelement und/oder einer (ggf. als phasen- und/oder frequenzabhängig ausgebildeten) Rückkopplung (z. B. über einen Kondensator) einen Integrator ausbildet (siehe hierzu auch Figur 6). Der Integrator dient dabei zur Speicherung einer Ladungsmenge, welche spezifisch ist für die von dem Sensorelement 20.1 bei der Umladung über ein Empfangssignal empfangen Ladungsmenge. Der Operationsverstärker OP' kann über einen Ausgang O mit einer Ansteuerungsvorrichtung 50.1 z. B. in der Form eines Mikrocontrollers ggf. über einen Analog-Digital-Wandler 50.2 verbunden sein, um die gespeicherte Ladungsmenge auszuwerten.

Zur Umladung kann vorteilhafterweise eine wiederholt durchgeführte Empfangsphase (auch Umladephase genannt) genutzt werden. Die Empfangsphase kann eine bestimmte Schaltphase sein, also ein Schaltzustand wenigstens eines Schalterelements S. Hierzu wird bspw. das wenigstens eine Schalterelement S, insbesondere wenigstens ein Umschalter S, wiederholt umgeschaltet, vorzugsweise mit einer Frequenz von 333 kHz. Die Empfangsphase liegt in diesem Fall dann vor, wenn das Schalterelement S einen Receive-Pfad r mit dem Sensorelement 20.1 elektrisch verbindet. Nach einem weiteren Umschalten des Schalterelements S in einen anderen Schaltzustand liegt hingegen eine Übertragungsphase (ggf. auch Aufladephase genannt) vor, in welcher das Schalterelement S einen Transmit-Pfad t mit dem Sensorelement 20.1 elektrisch verbindet. Beide Pfade r, t können dabei als Leitungen (z. B. auf einer Leiterplatte) ausgeführt sein, welche somit eine elektrisch leitende Verbindung bereitstellen.

Die Übertragungsphase kann dazu genutzt werden, um dem Sensorelement 20.1 Ladung zuzuführen, also eine Aufladung des kapazitiven Sensors zu bewirken. Hierzu wird bspw. das Sensorelement 20.1 in der Übertragungsphase elektrisch über das Schalterelement S und über den Transmit-Pfad t mit einer Übertragungsanordnung 30 verbunden. Dies bewirkt die Übertragung eines Ausgangssignals A über den Transmit-Pfad t, insbesondere von der Übertragungsanordnung 30 an das Sensorelement 20.1. Die Empfangsphase kann dagegen dafür genutzt werden, um aus dem Sensorelement 20.1 darin befindliche (aufgrund der Sensorkapazität CS gespeicherte) Ladung zu empfangen, also die Umladung zu bewirken. Hierzu wird bspw. das Sensorelement 20.1 in der Empfangsphase elektrisch über das Schalterelement S und über den Receive-Pfad r mit einer Halteanordnung 50.4 verbunden. Dies bewirkt die Übertragung eines Empfangssignals über den Receive-Pfad r, insbesondere von dem Sensorelement 20.1 an die Halteanordnung 50.4. Darüber hinaus kann auch noch die Schaltvorrichtung 60 wiederholt umgeschaltet werden, um abwechselnd die unterschiedlichen Sensorelemente 20.1 mit dem Receive- und Transmit-Pfad r,t zu verbinden.

Im Folgenden wird die Empfangsphase näher betrachtet, welche zur Auswertung bei der Sensorvorrichtung 20 dienen kann. In der Empfangsphase kann die mittels der Sensorkapazität CS gespeicherte Ladung "umgeladen" werden, also in Abhängigkeit (z. B. proportional) zur Sensorkapazität CS bzw. zur dadurch gespeicherten Ladung die Halteanordnung 50.4 mit der Haltekapazität CH (bspw. eines Haltekondensators) aufgeladen werden. Dabei kann die Umladung ggf. über ein Tiefpass-Filter 50.5 und/oder bspw. auch über einen nicht explizit gezeigten Stromspiegel erfolgen. Der daraufhin für die Detektion der Aktivierungshandlung relevante Ladezustand der Halteanordnung 50.4 bzw. des Haltekondensators kann insbesondere anhand einer Spannung über oder seriell zum Haltekondensator, optional über den Analog-Digital-Wandler 50.2, ermittelt werden. Hierzu kann der Analog-Digital-Wandler 50.2 einerseits z. B. über ein Tiefpass-Filter 50.5 mit der Halteanordnung 50.4 und andererseits mit der Ansteuerungsvorrichtung 50.1 verbunden sein. Darüber hinaus kann optional auch wenigstens ein weiteres Kontrollelement 50.7 (auch: Kompensator) mit dem Receive-Pfad r verbunden sein, um z. B. eine Kompensation von einem Ladungsüberschuss bei der Umladung vorzunehmen. Hierzu kann das Kontrollelement 50.7 bspw. eine Regelschaltung umfassen. Somit kann das Kontrollelement 50.7 (ggf. zusammen mit weiteren Elementen wie der Ansteuerungsvorrichtung 50.1) dazu ausgeführt sein, einen Ladungsüberschuss (wenn also die umgeladene Ladungsmenge nicht mehr durch die Haltekapazität CH gespeichert werden kann) zu detektieren und/oder eine Kompensation durchzuführen.

Die Ansteuerungsvorrichtung 50.1 der Kontrollvorrichtung 50 kann bspw. als ein Mikrocontroller oder dergleichen ausgeführt sein, und ggf. auch die (insbesondere wiederholte und/oder getaktete) Umschaltung des Schalterelements S durchführen. Insbesondere kann die Ansteuerungsvorrichtung 50.1 dies in Abhängigkeit von wenigstens einem Anpassungsmittel 50.3, vorzugsweise eines Computerprogramms, durchführen, um so eine Phasendauer der Empfangsphase und/oder der Übertragungsphase zu bestimmen und/oder zu variieren. Darüber hinaus kann durch die Ansteuerungsvorrichtung 50.1 auch die abwechselnde Durchführung der Empfangsphase und/oder der Übertragungsphase unterbrochen werden, also eine weitere Unterbrechungsphase eingeführt werden. Diese dient z. B. zum Pausieren der Ausgabe eines Ausgangssignals A und/oder der Übertragung des Empfangssignals, um bspw. den Energieverbrauch zu reduzieren.

Das Prinzip-Schaltbild gemäß Figur 2 macht deutlich, dass insbesondere durch die beschriebene Umschaltung des Schalterelements S ohne weitere Maßnahmen ein Rechtecksignal zur Ansteuerung und/oder Auswertung des Sensorelements 20.1 bewirkt wird. Dieses weist entsprechend ein sehr breites Frequenzspektrum auf. Ein solches ungünstiges Frequenzspektrum kann ohne weitere Maßnahmen dazu führen, dass eine störende elektromagnetische Abstrahlung (Emission) durch das Sensorelement 20.1 in die Umgebung des Fahrzeuges 1 erfolgt, und insbesondere in Frequenzbereichen, welche Störauswirkungen auf andere Funksignale oder dergleichen haben können.

Daher kann es als Maßnahme im Rahmen der Erfindung vorgesehen sein, dass eine phasenabhängige und/oder frequenzabhängige Übertragung und/oder Veränderung wenigstens eines Signals zur Ansteuerung und/oder Auswertung durchgeführt wird. So kann z. B. zur Ansteuerung (d. h. zur Übertragung an das Sensorelement 20.1 und/oder zur Aufladung und/oder zum Betreiben des Sensorelements 20.1) ein Signal, nämlich das Ausgangssignal A, direkt an einem Ausgang 30.2 einer Übertragungsanordnung 30 ausgegeben und/oder erzeugt werden, wobei über eine Signalformung und/oder Filterung die Breite des Frequenzspektrums des Signals, insbesondere die Oberschwingungen, und damit die Störauswirkung reduziert werden können. Als weiteres Signal kann für die Auswertung auch das Empfangssignal von dem Sensorelement 20.1 durch die phasen- und/oder frequenzabhängige Übertragung bzw. Veränderung beeinflusst werden, bspw. durch eine Verbindung der Übertragungsanordnung 30 mit der Halteanordnung 50.4, um hierdurch den Empfang des Empfangssignals zu steuern.

Von Vorteil ist es außerdem, wenn das Signal und/oder die Signalformung durch die Ansteuerungsvorrichtung 50.1 und/oder durch eine mit der Ansteuerungsvorrichtung 50.1 verbundene und/oder darin integrierte Ansteuerungsanordnung 50.6 beeinflusst werden. Diese können mit einem Eingang 30.1 der Übertragungsanordnung 30 verbunden sein, um ein Eingangssignal E (insbesondere Ansteuerungssignal E) für die Übertragungsanordnung 30 an dem Eingang 30.1 bereitzustellen. Auf diese Weise kann die Übertragungsanordnung 30 zwischen der Ansteuerungsvorrichtung 50.1 und dem Sensorelement 20.1 zwischengeschaltet sein, um die frequenz- und/oder phasenabhängige Übertragung bzw. Veränderung beim Eingangssignal E vorzunehmen. Diese erfolgt dabei insbesondere derart als eine vorteilhafte Frequenzfilterung, dass die störenden Frequenzen beim Eingangssignal E überwiegend herausgefiltert werden. Hierzu kann das Eingangssignal E, wenn es am Eingang 30.1 der Übertragungsanordnung 30 anliegt, gefiltert und als Ausgangssignal A am Ausgang 30.2 ausgegeben werden. Auch kann in Abhängigkeit von diesem übertragenen / veränderten (insbesondere gefilterten) Eingangssignal E durch die Übertragungsanordnung 30 ein geführtes Ausgangssignal A ausgegeben werden. Damit wird gewährleistet, dass die Form des übertragenen bzw. veränderten bzw. gefilterten Signals - und damit das gefilterte Frequenzspektrum - auch an dem Sensorelement 20.1 beibehalten wird. Unter "geführt" kann insbesondere verstanden werden, dass das Ausgangssignal A aktiv in Abhängigkeit von dem übertragenen bzw. veränderten bzw. gefilterten Eingangssignal E erzeugt und an dem Sensorelement 20.1 angelegt wird, z. B. durch die Nutzung eines Operationsverstärkers OP.

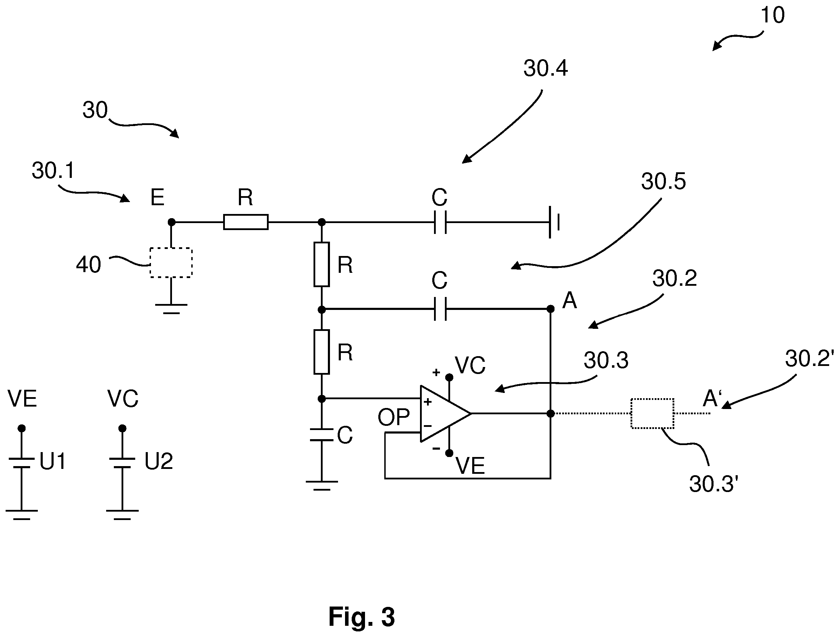

Wie Figur 2 und mit weiteren Einzelheiten auch Figur 6 schematisch zu entnehmen ist, kann die Übertragungsanordnung 30 auch mit einem Eingang der Halteanordnung 50.4 verbunden sein. Dabei umfasst die Halteanordnung 50.4 z. B. einen Integrator. Beispielhaft kann daher vorgesehen sein, dass ein Eingang der Übertragungsanordnung 30, insbesondere ein nicht invertierter Eingang "+" des Operationsverstärkers OP der Übertragungsanordnung 30, mit einem Eingang des Integrators, bevorzugt einem (nicht invertierten) Eingang "+" eines weiteren Operationsverstärkers OP' des Integrators, verbunden ist. Vorzugsweise ist diese Verbindung dafür ausgeführt, dass die Halteanordnung 50.4 in Abhängigkeit von der frequenz- und/oder phasenabhängigen Übertragung und/oder Veränderung durch die Übertragungsanordnung 30 das Empfangssignal von dem Sensorelement 20.1 über den Receive-Pfad r empfängt. Hierzu kann ein von der Übertragungsanordnung 30 bereitgestelltes Signal (z. B. am Eingang "+" des Operationsverstärkers OP in Figur 3 und 6), welches die frequenz- und/oder phasenabhängige Veränderung durch die Filterung aufweist, z. B. die Funktion der Halteanordnung 50.4 bzw. des Integrators beeinflussen. Wenn die Verbindung mit dem Eingang des Integrators erfolgt, kann dieses bereitgestellte Signal als eine Art Referenz für die Integration aufgefasst werden (z. B. durch die Verbindung mit dem nicht-invertierten Operationsverstärkereingang des Integrators beeinflusst das bereitgestellte Signal die Differenzspannung dieses weiteren Operationsverstärkers OP' des Integrators und ggf. über eine Rückkopplung bei dem Operationsverstärker OP' somit auch das Empfangssignal). Die Verschaltung der in Figur 6 gezeigten Bauelemente kann dabei derjenigen in Figur 2 und 3 entsprechen, wie durch gestrichelte Verbindungslinien verdeutlicht wird.

In Figur 3 ist die Übertragungsanordnung 30 mit weiteren Einzelheiten gezeigt. Die Schaltung zur Erzeugung des Eingangssignals E, also insbesondere die Kontrollvorrichtung 50, vorzugsweise die Ansteuerungsvorrichtung 50.1 und/oder die Ansteuerungsanordnung 50.6, wird schematisch durch eine Eingangssignalquelle 40 repräsentiert. Diese ist in der Lage, ein elektrisches Eingangssignal E, wie zumindest ein im Wesentlichen als Rechtecksignal ausgeführtes oder darauf basierendes Eingangssignal E, zu erzeugen. Auch kann die Ansteuerungsanordnung 50.6 ggf. eine weitergehende Signalformung des Eingangssignals E durchführen, z. B. über zuschaltbare Widerstände, um das Eingangssignal E zu formen. Hierzu kann die Ansteuerungsanordnung 50.6 auch durch die Ansteuerungsvorrichtung 50.1 angesteuert werden, um die Signalformung z. B. kontrolliert durch das Anpassungsmittel 50.3 durchzuführen. Der Eingang 30.1 ist elektrisch mit wenigstens einer ersten Filterkomponente 30.4, insbesondere einem RC-Glied, und/oder einer zweiten Filterkomponente 30.5, insbesondere weiteren Widerständen R und/oder Kondensatoren C zur Ausbildung eines Sallen-Key-Filters, verbunden. Die erste Filterkomponente 30.4 umfasst z. B. einen (ggf. einzigen) Widerstand R und einen (ggf. einzigen) Kondensator C. Bevorzugt kann durch die Verschaltung der beiden Filterkomponenten 30.4, 30.5 durch die Übertragungsanordnung 30 insgesamt ein Filter dritter Ordnung bereitgestellt werden. Die Nutzung eines Operationsverstärkers OP ermöglicht ferner die Ausbildung als aktives Filter, vorzugsweise Sallen-Key-Filter.

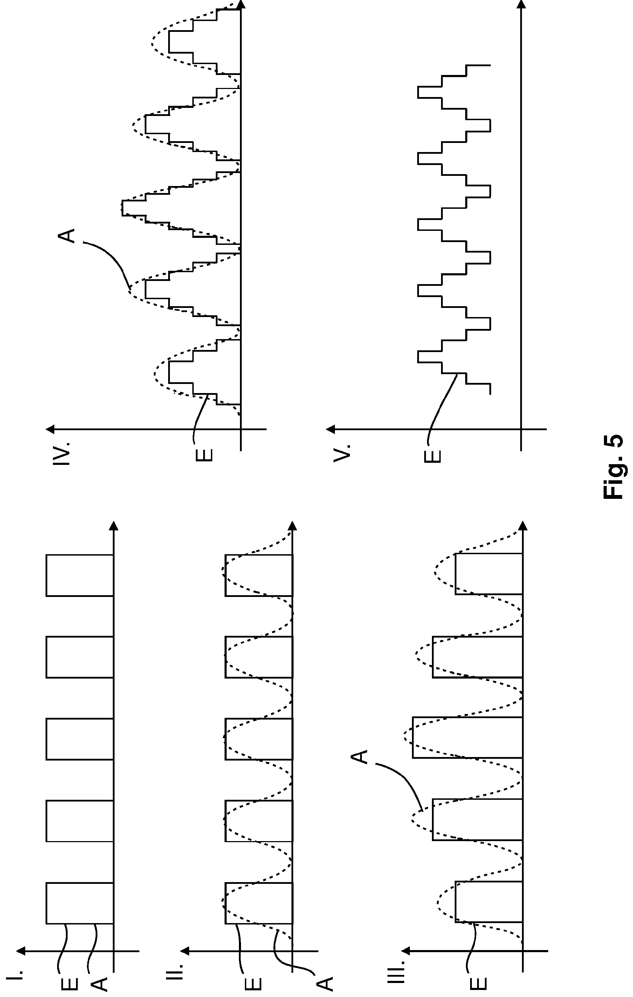

In Figur 2 ist die Ansteuerungsvorrichtung 50.1 schematisch über eine Leitung mit der Ansteuerungsanordnung 50.6 verbunden. Dies dient der vereinfachten Darstellung des Schaltbildes, wobei die Leitung ggf. auch als mehrere Leitungen verstanden werden kann, welche jeweilige Ausgänge der Ansteuerungsvorrichtung 50.1 mit jeweiligen Widerständen der Ansteuerungsanordnung 50.6 verbinden. So kann die Ansteuerungsvorrichtung 50.1 z. B. über wenigstens eine oder zwei oder drei oder vier separate elektrische Leitungen mit der Ansteuerungsanordnung 50.6 verbunden sein, insbesondere um über die Leitungen jeweils wenigstens einen Widerstand der Ansteuerungsanordnung 50.6 anzusteuern. Ferner können die Leitungen bspw. jeweils einen Ausgang der Ansteuerungsvorrichtung 50.1 mit wenigstens einem Widerstand der Ansteuerungsanordnung 50.6 verbinden, und vorzugsweise den jeweiligen Ausgang dann über den jeweiligen Widerstand / die jeweiligen Widerstände mit dem Eingang 30.1 elektrisch verbinden. Bspw. umfasst die Ansteuerungsanordnung 50.6 wenigstens zwei oder drei oder vier Widerstände, welche jeweils mit einem ersten Anschluss über eine jeweilige Leitung mit der Ansteuerungsvorrichtung 50.1 und mit einem zweiten Anschluss mit dem Eingang 30.1 verbunden sind. Da es sich hierbei um verschiedene Leitungen und Ausgänge der Ansteuerungsvorrichtung 50.1 handelt, können die Widerstände einzeln und/oder unabhängig voneinander angesteuert werden, um das Eingangssignal E am Eingang 30.1 geformt bereitzustellen. Es wird in anderen Worten ein programmierbarer Spannungsteiler durch die Ansteuerungsanordnung 50.6 gebildet. Dies ermöglicht eine Formung des Eingangssignals E, wie es zu Figur 5 näher erläutert wird.

Es ist erkennbar, dass die Filterkomponenten 30.4, 30.5 elektrisch mit einer Quellenvorrichtung 30.3, insbesondere einer Strom- und/oder Spannungsquellenvorrichtung 30.3, verbunden sein können. Im in Figur 3 gezeigten Beispiel ist die Quellenvorrichtung 30.3 als der Operationsverstärker OP ausgeführt, welcher im Sinne einer Sallen-Key-Filter-Konfiguration mit den Filterkomponenten 30.4, 30.5 verschaltet ist. Entsprechend kann der Operationsverstärker OP und/oder die Quellenvorrichtung 30.3 ggf. auch als eine weitere Filterkomponente verstanden werden. Die Quellenvorrichtung 30.3 bewirkt anhand des durch die Filterkomponenten 30.4, 30.5 gefilterten Eingangssignals E eine Ausgabe eines Ausgangssignals A am Ausgang 30.2. Zur aktiven Führung des Ausgangssignals A ist die Quellenvorrichtung 30.3 mit einer Versorgungsspannung verbunden. Dargestellt sind dabei beispielhaft eine erste Spannung U1 zur Bereitstellung eines ersten Versorgungspotentials VE und eine zweite Spannung U2 zur Bereitstellung eines zweiten Versorgungspotentials VC, wobei die Spannungen z. B. betragsgleich und unterschiedlicher Polarität sind. U1 beträgt bspw. -5 V und U2 bspw. +5 V. Durch eine entsprechende Auslegung der Bauelemente kann dabei eine Übertragungsanordnung 30 bereitgestellt werden, welche die Filtereigenschaften eines aktiven Tiefpassfilters aufweist, insbesondere dritter Ordnung und/oder mit einer Abschwächung in Höhe von -20 dB bei 1 MHz und/oder einer Grenzfrequenz von 470 kHz. In anderen Worten kann eine Oberwellenunterdrückung von mindestens -20 dB bereitgestellt werden. Das Filter eignet sich dabei besonders für eine Arbeitsfrequenz der Sensorvorrichtung 20 in Höhe von (im Wesentlichen) 333 kHz, welche durch die Frequenz der Umschaltungen zwischen den Empfangsphasen und/oder Übertragungsphasen bestimmt wird. Bspw. wird die Arbeitsfrequenz (oder auch weitere Arbeitsfrequenzen) also von der Umschaltfrequenz des Schalterelements S bestimmt oder entspricht dieser. Insbesondere können Oberschwingungen ab der 2. Harmonischen oder 3. Harmonischen effektiv unterdrückt werden.

Alternativ kann ggf. auch auf die Filterkomponenten 30.4, 30.5 verzichtet werden, sodass z. B. die Übertragungsanordnung 30 lediglich die gesteuerte Quellenvorrichtung 30 aufweist, um das Eingangssignal E im Wesentlichen unverändert zu übertragen und dann als Ausgangssignal A (z. B. als Rechtecksignal) ohne Filterung auszugeben. Ferner kann die Übertragungsanordnung 30 auch die Filtereigenschaften eines Allpass oder dergleichen aufweisen.

Eine weitere Alternativ und/oder Ergänzung der erfindungsgemäßen Anordnung 10 ist in Figur 3 in gestrichelten Linien gezeigt. Dabei kann am Ausgang 30.2, vorzugsweise an dem Operationsverstärker OP und/oder der Quellenvorrichtung 30.3 und/oder der wenigstens einen Filterkomponente 30.4, 30.5, eine Verbindung zu einer weiteren Quellenvorrichtung 30.3' vorgesehen sein, um einen alternativen Ausgang 30.2' bereitzustellen. Diese Ausbildung ist dabei nur optional, um bspw. eine Stromquelle und/oder einen Wandler als weitere Quellenvorrichtung 30.3' zu nutzen, um so in alternativer Weise ein geführtes Ausgangssignal A' ausgegeben. Diese Ausbildung mit der weiteren Quellenvorrichtung 30.3' kann zusätzlich zur gezeigten Ausbildung mit dem Operationsverstärker OP genutzt werden, oder auch die Quellenvorrichtung 30.3 ersetzen. Im letzteren Falle kann das Filter, welches durch die Filterkomponenten 30.4, 30.5 gebildet ist, auch als passives Filter ausgeführt sein und/oder die weitere Quellenvorrichtung 30.3' ebenfalls eine Filterkomponente zur Ausbildung eines aktiven Filters ausbilden. Grundsätzlich kann es sich daher bei dem Ausgangssignal A bzw. A' um eine zwangsgeführte Sensorspannung oder einen zwangsgeführten Sensorstrom handeln.

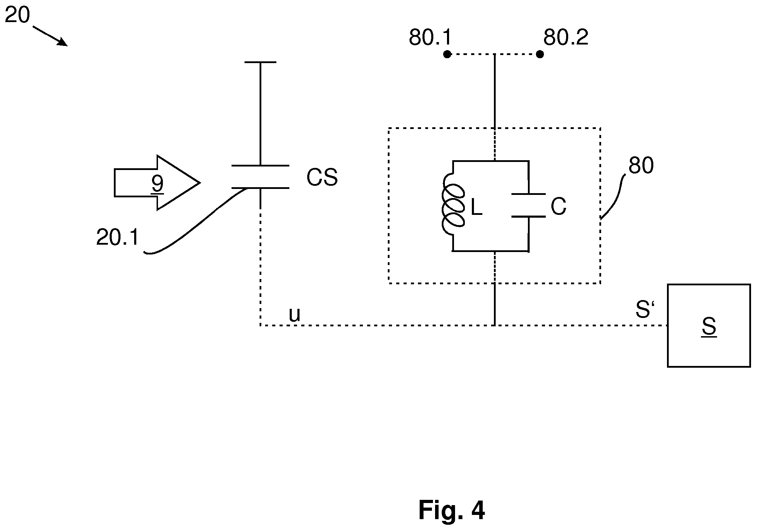

In Figur 4 ist der Übertragungsweg eines Signals S' zwischen dem Schalterelement S und dem wenigstens einen Sensorelement 20.1 gezeigt. Innerhalb dieses Übertragungswegs entlang eines Übertragungspfads u können noch weitere elektronische Elemente angeordnet sein, was durch eine gestrichelte Linie des Übertragungspfads u angedeutet ist. Diese weiteren Elemente können bspw. eine weitere Filterung des Signals S' bewirken. Das Schalterelement S verbindet je nach Schalterstellung (Schaltzustand) diesen Übertragungsweg mit dem Receive-Pfad r zur Auswertung oder dem Transmit-Pfad t zur Ansteuerung. In einer ersten Schalterstellung des Schalterelements S kann somit das Signal S' dem Ausgangssignal A entsprechen, welches von dem Ausgang 30.2 der Übertragungsanordnung 30 zum Sensorelement 20.1 übertragen wird. In einer zweiten Schalterstellung des Schalterelements S kann das Signal S' hingegen einem Empfangssignal entsprechen und zur Halteanordnung 50.4 über den Receive-Pfad r übertragen werden. Im letzteren Fall ist das Signal S spezifisch für die Erfassung, und kann z. B. durch die Kontrollvorrichtung 50 ausgewertet werden, um eine Aktivierungshandlung zu detektieren.

Wie weiter in Figur 4 dargestellt ist, kann eine Vorfilteranordnung 80, insbesondere ein Preselector 80, vorzugsweise in der Form eines Saugkreises und/oder eines Bandpassfilters oder eines Bandstoppfilters (Bandsperre), genutzt werden. Dadurch können störende Frequenzen des Signals S' herausgefiltert werden, welche ggf. durch das Sensorelement 20.1 (im Sinne einer Einstrahlung bzw. Immission) eintreten. Daraus wird deutlich, dass das Sensorelement 20.1 ggf. auch als eine Art Antenne angesehen werden kann, über welche Emissionen (aus der Sensorvorrichtung 20 in die Umgebung des Fahrzeuges 1) austreten und Immissionen (aus der Umgebung in die Sensorvorrichtung 20) eintreten können. Die Ausdrücke Emissionen und Immissionen werden hierbei im Sinne störender Funksignale bzw. elektromagnetischer Strahlung verwendet. Die Vorfilteranordnung 80 kann bspw. als ein LC-Schwingkreis und/oder Saugkreis ausgeführt sein, z. B. mit zueinander parallel geschalteten Kondensator C und Spule L. Die Vorfilteranordnung 80 ist beispielhaft mit einem ersten und zweiten Anschluss 80.1, 80.2 verbunden. Vorteilhafterweise kann der erste Anschluss 80.1 die Vorfilteranordnung 80 mit einem Versorgungspotential verbinden, und/oder der zweite Anschluss 80.2 die Vorfilteranordnung 80 mit einem Massepotential verbinden. Dies hat den Vorteil, dass Signalanteile des Signals S' im unerwünschten Frequenzbereich über wenigstens einen dieser Anschlüsse geleitet, d. h. abgeführt werden können. Hierzu wird die Vorfilteranordnung 80 für diesen ggf. unerwünschten Frequenzbereich niederohmig. Für die gewünschte Frequenz kann die Vorfilteranordnung 80 hingegen hochohmig werden, sodass das Signal S' für diese Frequenz nicht durch die Vorfilteranordnung 80 geleitet wird (die Vorfilteranordnung 80 wirkt demnach als Bandpass für die gewünschte Frequenz derart, dass die Vorfilteranordnung 80 die gewünschte Frequenz nicht abführt). Im Idealfall, also einem Betrieb ausschließlich mit einem Signal S' der gewünschten Frequenz, entsteht somit kein Verlust durch diese Filterung. Die Verlustleistung kann entsprechend durch diesen Aufbau deutlich reduziert werden. Es kann darüber hinaus möglich sein, dass in dem Receive-Pfad r und dem Transmit-Pfad t jeweils ein Widerstand und/oder eine Widerstandsanordnung für die Vorfilteranordnung 80 integriert sind, wobei vorzugsweise die Widerstände und/oder die Widerstandsanordnungen (im Wesentlichen) gleich (mit gleichem Widerstandswert und/oder gleicher Größe und/oder gleicher Impedanz) ausgeführt sind. Die Widerstände und/oder die Widerstandsanordnungen können dazu ausgeführt sein, eine Übertragungsfunktion der Vorfilteranordnung 80 anzupassen.

Figur 5 zeigt verschiedene Möglichkeiten II. bis V. zur Signalformung des Eingangssignals E (durchgehende Linie) und das daraus jeweils resultierende Ausgangssignal A (gestrichelte Linie). Zur Verdeutlichung wird die Darstellung I. gezeigt, in welcher keinerlei frequenz- und/oder phasenabhängige Veränderung und/oder nur eine frequenz- und/oder phasenabhängige Übertragung des Eingangssignals E durch die Übertragungsanordnung 30 erfolgt. In Darstellung II. wird hingegen eine Filterung des Eingangssignals E durch die Übertragungsanordnung 30, also insbesondere über die Filterkomponenten, durchgeführt. Die Filterkomponenten bewirken dabei bevorzugt die Bereitstellung eines Analog-Tiefpasses, welcher die Rechteck-Form des Eingangssignals E verändert. Auf diese Weise kann ein sinusartiges Ausgangssignal A bereitgestellt werden. Darstellung III. zeigt ein Beispiel für eine weitergehende Signalformung, bei welcher neben der Filterung durch die Filterkomponenten der Übertragungsanordnung 30 auch eine Modulation (insbesondere als ein "Verschleifen") durch die Ansteuerungsvorrichtung 50.1 und/oder die Ansteuerungsanordnung 50.6 bewirkt wird. Das Eingangssignal E weicht hierbei von der ursprünglichen Rechteck-Form ab und zeigt aufgrund der Modulation eine zeitlich auf- und wieder absteigende Amplitude einzelner Pulse. Diese weitergehende Signalformung kann bspw. direkt bei der Erzeugung des Eingangssignals E durch die Ansteuerungsvorrichtung 50.1 bewirkt werden. Eine Weiterentwicklung zeigt Darstellung IV., bei welcher zusätzlich zur Modulation gemäß III. eine weitere Modulation zum Einsatz kommt. Dabei weist das Eingangssignal E eine Stufenform auf, welche die Filterung durch die Übertragungsanordnung 30 begünstigen kann. In anderen Worten kann gemäß Darstellung III. die Ansteuerungsanordnung 50.6 und/oder eine Ansteuerungsvorrichtung 50.1 dazu ausgeführt sein, die Formung des Eingangssignals E durch Erzeugung eines rechteckartigen Signals mit zeitlich aufeinanderfolgenden Pulsen durchzuführen, wobei sich die Pulsamplituden unterschiedlicher Pulse zeitlich verändern, vorzugsweise mit einer zeitlich auf- und wieder absteigenden Amplitude (insbesondere innerhalb eines Bursts), wobei vorzugsweise die Pulsamplitude einzelner Pulse (im Wesentlichen) über die Pulsbreite konstant bleibt. Dagegen kann in Darstellung IV. zusätzlich die Pulsamplitude einzelner Pulse sich ebenfalls innerhalb der Pulsbreite zeitlich verändern, vorzugsweise eine Stufenform aufweisen. Auf diese Weise kann besonders zuverlässig ein sinusartiges Ausgangssignal A erzeugt werden.

Ein besonders vorteilhaftes Beispiel für ein Eingangssignal E ist in Darstellung V. gezeigt. Dieses Signal kann beispielweise durch eine Signalformung erhalten werden, welche durch die Ansteuerungsvorrichtung 50.1 und/oder die Ansteuerungsanordnung 50.6 bereitgestellt wird. Hierzu ist die Ansteuerungsanordnung 50.6 z. B. als ein programmierbarer Spannungsteiler ausgeführt. Die dargestellte Form weist mehrere zeitlich aufeinanderfolgende rechteckartige Pulse auf, welche sich hinsichtlich ihrer Pulsamplitude voneinander unterscheiden. Hierzu kann für die Ansteuerungsanordnung 50.6 über die verschiedenen Leitungen, welche jeweils mit wenigstens einem Widerstand der Ansteuerungsanordnung 50.6 verbunden sind, durch die Ansteuerungsvorrichtung 50.1 ein Ansteuerungssignal ausgegeben werden. Dieses ist bspw. in der Art einer Pulsweitenmodulation oder dergleichen ausgeführt, und unterscheidet sich für unterschiedliche Leitungen. Die Widerstände der unterschiedlichen Leitungen sind bspw. unterschiedlich groß. Auf diese Weise kann das Eingangssignal E sehr genau mit der gewünschten Form erzeugt werden. Durch die Symmetrie der Form, insbesondere der gleichartigen an- und absteigenden Pulsfolge und/oder dem gleichbleibenden Absolutwert der Amplitudendifferenz für unterschiedliche Pulse, kann ein besonders vorteilhaftes Spektrum erzeugt werden. Insbesondere kann hierdurch die 3. Harmonische im Spektrum des Eingangssignals E (ggf. vollständig) eliminiert werden.

Die voranstehende Erläuterung der Ausführungsformen beschreibt die vorliegende Erfindung ausschließlich im Rahmen von Beispielen.

### Bezugszeichenliste

- 1: Fahrzeug
- 2: Heckklappe
- 3: Stoßfänger
- 8: Benutzer
- 9: Körperteil, Aktivierungsmittel

- 10: Anordnung, Schaltungsanordnung

- 20: Sensorvorrichtung
- 20.1: Sensorelektrode, Sensorelement
- 20.2: Massepotential

- 30: Übertragungsanordnung
- 30.1: Eingang
- 30.2: Ausgang
- 30.3: Quellenvorrichtung, Strom- und/oder Spannungsquellenvorrichtung
- 30.4: erste Filterkomponente, RC-Glied für Tiefpass 1. Ordnung
- 30.5: zweite Filterkomponente, weitere Anordnung für Tiefpass 2. Ordnung

- 40: Eingangssignalquelle, digitale Signalerzeugung

- 50: Kontrollvorrichtung
- 50.1: Ansteuerungsvorrichtung, Mikrocontroller
- 50.2: Analog-Digital-Wandler
- 50.3: Anpassungsmittel, Software
- 50.4: Halteanordnung
- 50.5: Tiefpass-Filter
- 50.6: Ansteuerungsanordnung
- 50.7: weiteres Kontrollelement

- 60: Schaltvorrichtung

- 80: Vorfilteranordnung, Preselector
- 80.1: erster Anschluss, Versorgungsanschluss
- 80.2: zweiter Anschluss, Masseanschluss

- r: Receive-Pfad
- t: Transmit-Pfad
- A: Ausgangssignal
- C: Kondensator
- CH: Haltekapazität
- CS: Sensorkapazität
- E: Eingangssignal
- O: Ausgang
- OP: Operationsverstärker
- OP': weiterer Operationsverstärker
- L: Spule
- R: Widerstand
- S: Schalterelement
- u: Übertragungspfad
- U1: erste Spannung
- U2: zweite Spannung
- VC: Versorgungsspannung, zweites Potential
- VE: Versorgungsspannung, erstes Potential

## Patentansprüche

1. Anordnung (10) für eine kapazitive Sensorvorrichtung (20) eines Fahrzeuges (1), insbesondere zur Ansteuerung und/oder Auswertung bei der kapazitiven Sensorvorrichtung (20) zur Detektion einer Aktivierungshandlung beim Fahrzeug (1), aufweisend:
- wenigstens eine Sensorelektrode (20.1) zur Erfassung einer Veränderung in einer Umgebung des Fahrzeuges (1),
- eine Übertragungsanordnung (30) zur frequenz- und/oder phasenabhängigen Übertragung eines elektrischen Eingangssignals (E) und zur Ausgabe eines Ausgangssignals (A),
- einen Ausgang (30.2) der Übertragungsanordnung (30), welcher elektrisch mit der Sensorelektrode (20.1) verbunden ist, um das Ausgangssignal (A) an der Sensorelektrode (20.1) auszugeben,
wobei die Übertragungsanordnung (30) eine gesteuerte Quellenvorrichtung (30.3) aufweist, um das Ausgangssignal (A) in Abhängigkeit von der frequenz- und/oder phasenabhängigen Übertragung des Eingangssignals (E) zu erzeugen,
wobei eine Eingangssignalquelle (40) derart zur Bereitstellung des Eingangssignals (E) ausgeführt ist, dass das Eingangssignal (E) als ein auf einem Rechtecksignal basierendes Signal ausgeführt ist, welches durch Signalformung aktiv verändert ist, und zwar durch ein Verschleifen der Flanken des Rechtecksignals, um die frequenz- und/oder phasenabhängige Übertragung, vorzugsweise eine Oberwellenunterdrückung, durch die Übertragungsanordnung (30) zu unterstützen.

2. Anordnung (10) nach Anspruch 1,
**dadurch gekennzeichnet,**
**dass** die Quellenvorrichtung (30.3) als eine reale niederohmig gesteuerte Strom- und/oder Spannungsquelle ausgebildet ist, um das erzeugte Ausgangssignal (A) als ein geführtes elektrisches Signal an der Sensorelektrode (20.1) auszugeben,
und/oder dass die Quellenvorrichtung (30.3) als ein aktives Bauelement ausgebildet ist, bevorzugt als ein Operationsverstärker (OP), wobei die Quellenvorrichtung (30.3) direkt mit einer Versorgungsspannung (VC, VE) verbunden ist, um aktiv das Ausgangssignal (A) zu erzeugen.

3. Anordnung (10) nach einem der vorhergehenden Ansprüche,
**dadurch gekennzeichnet,**
**dass** die Übertragungsanordnung (30) wenigstens eine Filterkomponente (30.4, 30.5) zur Ausbildung eines elektronischen Filters aufweist, vorzugsweise eines Tiefpass- oder Allpass- oder Bandpass-Filters, um die frequenz- und/oder phasenabhängige Übertragung des Eingangssignals (E) durchzuführen, wobei bevorzugt die Quellenvorrichtung (30.3) mit wenigstens einer Filterkomponente (30.4, 30.5) verschaltet ist, sodass ein aktives Filter, besonders bevorzugt ein Sallen-Key-Filter, ausgebildet ist,
und/oder dass die Übertragungsanordnung (30) eine erste Filterkomponente (30.4), insbesondere zur Ausbildung eines RC-Tiefpass-Filters, vorzugsweise erster Filterordnung, und eine zweite Filterkomponente (30.5), insbesondere zur Ausbildung eines Sallen-Key-Filters, vorzugsweise zweiter Filterordnung, aufweist, wobei die Filterkomponenten (30.4, 30.5) miteinander verschaltet sind, um gemeinsam die frequenz- und/oder phasenabhängige Übertragung des Eingangssignals (E) durchzuführen und die Filterordnung der Übertragungsanordnung (30) zu erhöhen.

4. Anordnung (10) nach einem der vorhergehenden Ansprüche,
**dadurch gekennzeichnet,**
**dass** das Ausgangssignal (A) in Abhängigkeit von der frequenz- und/oder phasenabhängige Übertragung des Eingangssignals (E) dadurch erzeugbar ist, dass die Quellenvorrichtung (30.3) mit wenigstens einer Filterkomponente (30.4, 30.5) verschaltet ist, sodass das durch die Filterkomponente (30.4, 30.5) veränderte Eingangssignal (E) an einem Steuereingang der Quellenvorrichtung (30.3) anliegt, um die Quellenvorrichtung (30.3) hinsichtlich der Ausgabe des Ausgangssignals (A) zu steuern, und ein Ausgang der Quellenvorrichtung (30.3) mit dem Ausgang (30.2) der Übertragungsanordnung (30) verbunden ist oder diesem entspricht.

5. Anordnung (10) nach einem der vorhergehenden Ansprüche,
**dadurch gekennzeichnet,**
**dass** die Eingangssignalquelle (40) mit einem Eingang (30.1) der Übertragungsanordnung (30) verbunden ist, um das Eingangssignal (E) an dem Eingang (30.1) bereitzustellen, wobei die Eingangssignalquelle (40) hierzu wenigstens eine Ansteuerungsvorrichtung (50.1) aufweist.

6. Anordnung (10) nach einem der vorhergehenden Ansprüche,
**dadurch gekennzeichnet,**
**dass** die Übertragungsanordnung (30) dazu ausgeführt ist, eine Unterdrückung von Oberschwingungen des Eingangssignals (E) durchzuführen, um eine Emission von Signalen in einem störenden Frequenzbereich durch die Sensorelektrode (20.1) zumindest zu reduzieren.

7. Anordnung (10) nach einem der vorhergehenden Ansprüche,
**dadurch gekennzeichnet,**
**dass** die Quellenvorrichtung (30.3) elektrisch mit einer Fahrzeugelektronik, insbesondere einer Kontrollvorrichtung (50), verbunden ist, um eine Abschaltung der Quellenvorrichtung (30.3) durchzuführen, sodass die Anordnung (10) in einen Energiesparmodus überführbar ist.

8. Anordnung (10) nach einem der vorhergehenden Ansprüche,
**dadurch gekennzeichnet,**
**dass** eine Kontrollvorrichtung (50) vorgesehen ist, welche elektrisch mit der Sensorelektrode (20.1) verschaltet ist, um die Erfassung der Veränderung in der Umgebung des Fahrzeuges (1) durch die wenigstens eine Sensorelektrode (20.1) dadurch auszuwerten, dass eine veränderliche Kapazität (CS) der Sensorvorrichtung (20) mittels des Ausgangssignals (A) durch die Kontrollvorrichtung (50) auswertbar ist,
und/oder dass eine Kontrollvorrichtung (50) vorgesehen ist, um die Erfassung der Veränderung in der Umgebung des Fahrzeuges (1) durch die wenigstens eine Sensorelektrode (20.1) dadurch auszuwerten, dass in wiederholt durchgeführten Umladephasen eine Halteanordnung (50.4) der Kontrollvorrichtung (50) in Abhängigkeit von einer veränderlichen Kapazität (CS) der Sensorvorrichtung (20) geladen wird, sodass in den Umladephasen eine Ladungsakkumulation bei der Halteanordnung (50.4) erfolgt.

9. Anordnung (10) nach einem der vorhergehenden Ansprüche,
**dadurch gekennzeichnet,**
**dass** die Anordnung (10) zur Integration in einen Türgriff des Fahrzeuges (1) und/oder in einen Heckbereich und/oder Seitenbereich und/oder Frontbereich des Fahrzeuges (1) und/oder in eine Stoßstange (3) des Fahrzeuges (1) angepasst ist, insbesondere dass die Sensorelektrode (20.1) eine längliche Erstreckung aufweist, welche an die Länge des Türgriffs und/oder der Stoßstange (3) und/oder an eine Erstreckung des Fahrzeughecks in Fahrzeugquerrichtung angepasst ist.

10. Sensorvorrichtung (20) für ein Fahrzeug (1), aufweisend:
- eine Anordnung (10) nach einem der vorhergehenden Ansprüche,
- eine Kontrollvorrichtung (50), welche mit der Anordnung (10) elektrisch verbunden ist, um ein Eingangssignal (E) zur Auswertung einer veränderlichen Kapazität (CS) der Sensorvorrichtung (20) für die Anordnung (10) bereitzustellen, wobei die Kontrollvorrichtung (50) elektrisch mit einer Fahrzeugelektronik verbindbar ist, um eine Fahrzeugfunktion in Abhängigkeit von der Auswertung zu aktivieren.

11. Außentürgriff (4) für ein Fahrzeug (1) mit einer Anordnung (10) nach einem der vorhergehenden Ansprüche.

12. Verfahren (10) zum Betreiben einer kapazitiven Sensorvorrichtung (20) eines Fahrzeuges (1), insbesondere zur Ansteuerung und/oder Auswertung bei der kapazitiven Sensorvorrichtung (20) zur Detektion einer Aktivierungshandlung beim Fahrzeug (1), wobei die nachfolgenden Schritte durchgeführt werden:
a) Erzeugen eines elektrischen Eingangssignals (E),
b) Durchführen einer frequenz- und/oder phasenabhängigen Übertragung des elektrischen Eingangssignals (E),
c) Ausgabe eines Ausgangssignals (A) derart, dass ein geführtes elektrisches Signal in Abhängigkeit von der frequenz- und/oder phasenabhängigen Übertragung des Eingangssignals (E) an einer Sensorelektrode (20.1) ausgegeben wird,
wobei die kapazitive Sensorvorrichtung (20) eine Anordnung (10) nach einem der vorhergehenden Ansprüche 1-9 aufweist.

## Claims

1. An arrangement (10) for a capacitive sensor device (20) of a vehicle (1), in particular for controlling and/or evaluating the capacitive sensor device (20) for detecting an activation action at the vehicle (1), comprising:
- at least one sensor electrode (20.1) for detecting a change in an environment of the vehicle (1),
- a transmission arrangement (30) for frequency- and/or phase-dependent transmission of an electrical input signal (E) and for outputting an output signal (A),
- an output (30.2) of the transmission arrangement (30), which is electrically connected to the sensor electrode (20.1) to output the output signal (A) at the sensor electrode (20.1),
wherein the transmission arrangement (30) comprises a controlled source device (30.3) for generating the output signal (A) as a function of the frequency- and/or phase-dependent transmission of the input signal (E),
wherein an input signal source (40) is configured to provide the input signal (E) such that the input signal (E) is configured as a signal based on a square-wave signal that is actively modified by signal shaping, specifically by smoothing the edges of the square-wave signal, in order to support the frequency- and/or phase-dependent transmission, preferably a harmonic suppression, by the transmission arrangement (30).

2. An arrangement (10) according to claim 1,
**characterized in that**
the source device (30.3) is configured as a real, low-impedance-controlled current and/or voltage source to output the generated output signal (A) as a guided electrical signal at the sensor electrode (20.1),
and/or that the source device (30.3) is configured as an active component, preferably as an operational amplifier (OP), wherein the source device (30.3) is directly connected to a supply voltage (VC, VE) to actively generate the output signal (A).

3. An arrangement (10) according to one of the preceding claims,
**characterized in that**
the transmission arrangement (30) comprises at least one filter component (30.4, 30.5) for forming an electronic filter, preferably a low-pass, all-pass, or band-pass filter, to perform frequency- and/or phase-dependent transmission of the input signal (E), wherein the source device (30.3) is preferably connected to at least one filter component (30.4, 30.5) such that an active filter, particularly preferably a Sallen-Key filter, is formed,
and/or that the transmission arrangement (30) comprises a first filter component (30.4), in particular for forming an RC low-pass filter, preferably of the first-order type, and a second filter component (30.5), in particular for forming a Sallen-Key filter, preferably of the second-order type, wherein the filter components (30.4, 30.5) are interconnected to jointly perform the frequency- and/or phase-dependent transmission of the input signal (E) and to increase the filter order of the transmission arrangement (30).

4. An arrangement (10) according to one of the preceding claims,
**characterized in that**
the output signal (A) can be generated as a function of the frequency- and/or phase-dependent transmission of the input signal (E) by connecting the source device (30.3) to at least one filter component (30.4, 30.5) such that the input signal (E) modified by the filter component (30.4, 30.5) is applied to a control input of the source device (30.3) to control the source device (30.3) with respect to the output of the output signal (A), and an output of the source device (30.3) is connected to or corresponds to the output (30.2) of the transmission arrangement (30).

5. An arrangement (10) according to one of the preceding claims,
**characterized in that**
the input signal source (40) is connected to an input (30.1) of the transmission arrangement (30) to provide the input signal (E) at the input (30.1), wherein the input signal source (40) comprises at least one control device (50.1) for this purpose.

6. An arrangement (10) according to any of the preceding claims,
**characterized in that**
the transmission arrangement (30) is configured to suppress harmonics of the input signal (E) in order to at least reduce the emission of signals in an interfering frequency range by the sensor electrode (20.1).

7. An arrangement (10) according to one of the preceding claims,
**characterized in that**
the source device (30.3) is electrically connected to a vehicle electronics system, in particular a control device (50), to perform a shutdown of the source device (30.3) so that the arrangement (10) can be switched to an energy-saving mode.

8. An arrangement (10) according to any of the preceding claims,
**characterized in that**
a control device (50) is provided, which is electrically connected to the sensor electrode (20.1) to evaluate the detection of the change in the environment of the vehicle (1) by the at least one sensor electrode (20.1) by a variable capacitance (CS) of the sensor device (20) being evaluable by means of the output signal (A) by the control device (50),
and/or that a control device (50) is provided to evaluate the detection of the change in the environment of the vehicle (1) by the at least one sensor electrode (20.1) by, during repeatedly performed charging phases, a holding arrangement (50.4) of the control device (50) being charged as a function of a variable capacitance (CS) of the sensor device (20), such that a charge accumulation occurs at the holding arrangement (50.4) during the charging phases.

9. An arrangement (10) according to any of the preceding claims,
**characterized in that**
the arrangement (10) is adapted for integration into a door handle of the vehicle (1) and/or into a rear area and/or side area and/or front area of the vehicle (1) and/or into a bumper (3) of the vehicle (1), in particular that the sensor electrode (20.1) has an elongated extension which is adapted to the length of the door handle and/or the bumper (3) and/or to an extension of the vehicle rear in the vehicle transverse direction.

10. Sensor device (20) for a vehicle (1), comprising:
- an arrangement (10) according to one of the preceding claims,
- a control device (50) that is electrically connected to the arrangement (10) to provide an input signal (E) for evaluating a variable capacitance (CS) of the sensor device (20) for the arrangement (10), wherein the control device (50) is electrically connectable to a vehicle electronics system to activate a vehicle function depending on the evaluation.

11. Exterior door handle (4) for a vehicle (1) comprising an arrangement (10) according to one of the preceding claims.

12. Method (10) for operating a capacitive sensor device (20) of a vehicle (1), in particular for controlling and/or evaluating the capacitive sensor device (20) to detect an activation action on the vehicle (1), wherein the following steps are performed:
a) generating an electrical input signal (E),
b) performing a frequency- and/or phase-dependent transmission of the electrical input signal (E),
c) outputting an output signal (A) such that a guided electrical signal as a function of the frequency- and/or phase-dependent transmission of the input signal (E) is output to a sensor electrode (20.1), wherein the capacitive sensor device (20) comprises an arrangement (10) according to one of the preceding claims 1 through 9.

## Revendications

1. Dispositif (10) pour un capteur capacitif (20) d'un véhicule (1), en particulier pour la commande et/ou l'évaluation du capteur capacitif (20) en vue de la détection d'une action d'activation sur le véhicule (1), comprenant :
- au moins une électrode de capteur (20.1) destinée à détecter un changement dans l'environnement du véhicule (1),
- un dispositif de transmission (30) destiné à la transmission, en fonction de la fréquence et/ou de la phase, d'un signal d'entrée électrique (E) et à la délivrance d'un signal de sortie (A),
- une sortie (30.2) du dispositif de transmission (30), qui est reliée électriquement à l'électrode de capteur (20.1) afin de délivrer le signal de sortie (A) au niveau de l'électrode de capteur (20.1),
le dispositif de transmission (30) comportant un dispositif de source commandé (30.3) pour générer le signal de sortie (A) en fonction de la transmission, dépendante de la fréquence et/ou de la phase, du signal d'entrée (E),
une source de signal d'entrée (40) étant conçue pour fournir le signal d'entrée (E) de telle sorte que le signal d'entrée (E) est conçu comme un signal basé sur un signal rectangulaire, qui est activement modifié par mise en forme du signal, notamment par lissage des flancs du signal rectangulaire, afin de favoriser la transmission dépendante de la fréquence et/ou de la phase, de préférence une suppression des harmoniques, par le dispositif de transmission (30).

2. Dispositif (10) selon la revendication 1,
**caractérisé en ce**
**que** le dispositif de source (30.3) est conçu comme une source de courant et/ou de tension réelle commandée à faible impédance, afin de délivrer le signal de sortie généré (A) sous forme de signal électrique guidé au niveau de l'électrode de capteur (20.1),
et/ou en ce que le dispositif de source (30.3) est conçu comme un composant actif, de préférence comme un amplificateur opérationnel (OP), le dispositif de source (30.3) étant directement connecté à une tension d'alimentation (VC, VE) afin de générer activement le signal de sortie (A).

3. Dispositif (10) selon l'une des revendications précédentes,
**caractérisé en ce**
**que** le dispositif de transmission (30) comporte au moins un composant de filtrage (30.4, 30.5) pour former un filtre électronique, de préférence un filtre passe-bas, passe-tout ou passe-bande, afin d'effectuer la transmission du signal d'entrée (E) en fonction de la fréquence et/ou de la phase, le dispositif de source (30.3) étant de préférence connecté à au moins un composant de filtrage (30.4, 30.5), de sorte qu'un filtre actif, de préférence un filtre de Sallen-Key, est formé,
et/ou que le dispositif de transmission (30) comporte un premier composant de filtrage (30.4), en particulier pour former un filtre passe-bas RC, de préférence du premier ordre, et un deuxième composant de filtrage (30.5), notamment pour former un filtre de Sallen-Key, de préférence du deuxième ordre, les composants de filtrage (30.4, 30.5) étant interconnectés afin d'effectuer conjointement la transmission dépendante de la fréquence et/ou de la phase du signal d'entrée (E) et d'augmenter l'ordre de filtrage du dispositif de transmission (30).

4. Dispositif (10) selon l'une des revendications précédentes,
**caractérisé en ce**
**que** le signal de sortie (A) peut être généré en fonction de la transmission dépendante de la fréquence et/ou de la phase du signal d'entrée (E) par le fait que le dispositif de source (30.3) est interconnecté avec au moins un composant de filtrage (30.4, 30.5), de sorte que le signal d'entrée (E) modifié par le composant de filtrage (30.4, 30.5) soit appliqué à une entrée de commande du dispositif de source (30.3) afin de commander le dispositif de source (30.3) en ce qui concerne l'émission du signal de sortie (A), et une sortie du dispositif de source (30.3) est reliée à la sortie (30.2) du dispositif de transmission (30) ou correspond à celle-ci.

5. Dispositif (10) selon l'une des revendications précédentes,
**caractérisé en ce**
**que** la source de signal d'entrée (40) est reliée à une entrée (30.1) du dispositif de transmission (30) afin de fournir le signal d'entrée (E) à l'entrée (30.1), la source de signal d'entrée (40) comportant à cet effet au moins un dispositif de commande (50.1).

6. Dispositif (10) selon l'une des revendications précédentes,
**caractérisé en ce**
**que** le dispositif de transmission (30) est conçu pour effectuer une suppression des harmoniques du signal d'entrée (E) afin de réduire au moins l'émission de signaux dans une gamme de fréquences parasite par l'électrode de capteur (20.1).

7. Dispositif (10) selon l'une des revendications précédentes,
**caractérisé en ce**
**que** le dispositif de source (30.3) est relié électriquement à un système électronique du véhicule, en particulier à un dispositif de commande (50), afin de procéder à une mise hors tension du dispositif de source (30.3), de sorte que le dispositif (10) puisse être mis en mode d'économie d'énergie.

8. Dispositif (10) selon l'une des revendications précédentes,
**caractérisé en ce**
**qu'**il est prévu un dispositif de commande (50) qui est connecté électriquement à l'électrode de capteur (20.1) afin d'évaluer la détection de la variation dans l'environnement du véhicule (1) par au moins une électrode de capteur (20.1) en ce qu'une capacité variable (CS) du dispositif capteur (20) peut être évaluée au moyen du signal de sortie (A) par le dispositif de commande (50),
et/ou qu'un dispositif de commande (50) est prévu pour évaluer la détection de la variation dans l'environnement du véhicule (1) par au moins une électrode de capteur (20.1) en ce que, au cours de phases de recharge répétées, un dispositif de maintien (50.4) du dispositif de commande (50) est chargé en fonction d'une capacité variable (CS) du dispositif capteur (20), de sorte qu'une accumulation de charge se produit au niveau du dispositif de maintien (50.4) pendant les phases de recharge.

9. Dispositif (10) selon l'une des revendications précédentes,
**caractérisé en ce**
**que** le dispositif (10) est adapté pour être intégré dans une poignée de porte du véhicule (1) et/ou dans une zone arrière et/ou une zone latérale et/ou une zone avant du véhicule (1) et/ou dans un pare-chocs (3) du véhicule (1), en particulier **en ce que** l'électrode de capteur (20.1) présente une extension allongée qui est adaptée à la longueur de la poignée de porte et/ou du pare-chocs (3) et/ou à une extension de l'arrière du véhicule dans le sens transversal du véhicule.

10. Dispositif de capteur (20) pour un véhicule (1), comprenant :
- un dispositif (10) selon l'une des revendications précédentes,
- un dispositif de commande (50) qui est relié électriquement au dispositif (10) afin de fournir un signal d'entrée (E) pour l'évaluation d'une capacité variable (CS) du dispositif de capteur (20) pour le dispositif (10), le dispositif de commande (50) pouvant être relié électriquement à un système électronique du véhicule afin d'activer une fonction du véhicule en fonction de l'évaluation.

11. Poignée de porte extérieure (4) pour un véhicule (1) comprenant un dispositif (10) selon l'une des revendications précédentes.

12. Procédé (10) pour faire fonctionner un dispositif capteur capacitif (20) d'un véhicule (1), en particulier pour la commande et/ou l'évaluation au niveau du dispositif capteur capacitif (20) en vue de la détection d'une action d'activation sur le véhicule (1), dans lequel les étapes suivantes sont exécutées :
a) génération d'un signal d'entrée électrique (E),
b) réalisation d'une transmission dépendante de la fréquence et/ou de la phase du signal d'entrée électrique (E),
c) émission d'un signal de sortie (A) de telle sorte qu'un signal électrique guidé en fonction de la transmission dépendante de la fréquence et/ou de la phase du signal d'entrée (E) soit émis au niveau d'une électrode de capteur (20.1), le dispositif de capteur capacitif (20) comportant un dispositif (10) selon l'une des revendications 1 à 9 précédentes.
